# EUROPEAN PATENT APPLICATION

(11) **EP 4 668 315 A1**
(43) Date of publication of application: **24.12.2025**
(21) Application number: 24756855.3
(22) Date of filing: 13.02.2024
(51) Int. Cl.: H01L 21/301

(54) **COMPOSITION FOR FORMING PROTECTIVE FILM FOR SEMICONDUCTOR CHIP MANUFACTURE, SEMICONDUCTOR SUBSTRATE, SEMICONDUCTOR CHIP, AND METHOD FOR MANUFACTURING SEMICONDUCTOR CHIP**

(30) Priority: 14.02.2023 JP 2023021165
(71) Applicant: Nissan Chemical Corporation, Tokyo 103-6119 (JP)
(72) Inventor: KAMIBAYASHI, Satoshi, Toyama-shi, Toyama 939-2792 (JP); MORIYA, Shunsuke, Toyama-shi, Toyama 939-2792 (JP); KISHIOKA, Takahiro, Toyama-shi, Toyama 939-2792 (JP)
(74) Representative: Hoffmann Eitle
(86) International application number: PCT/JP2024/004738
(87) International publication number: WO 2024/172010

(57) **Abstract**

Provided is a semiconductor chip-manufacturing protective film-forming composition capable of easily forming a semiconductor chip-manufacturing protective film to be disposed on a semiconductor chip in order to provide, by a simpler method, a semiconductor chip with a protective film capable of protecting a semiconductor chip from damage accompanying transportation when an individual semiconductor chip obtained by dicing a semiconductor substrate is transported. A semiconductor chip-manufacturing protective film-forming composition for preventing damage to a circuit surface or a back surface of a semiconductor substrate or a semiconductor chip, the semiconductor chip-manufacturing protective film-forming composition containing a polymer and a solvent, wherein the polymer is selected from a phenolic hydroxy group-containing polymer and a carboxy group-containing polymer.

## Description

### Technical Field

The present invention relates to a semiconductor chip-manufacturing protective film-forming composition for forming a semiconductor chip-manufacturing protective film to be disposed on a semiconductor chip, a semiconductor substrate and a semiconductor chip having the semiconductor chip-manufacturing protective film, and a method for manufacturing a semiconductor chip.

### Background Art

In manufacturing a semiconductor device, particularly in a so-called post-process, a semiconductor substrate (for example, a wafer) on which a circuit is formed is attached to a support sheet (for example, a dicing tape), and then the semiconductor substrate is diced to obtain a semiconductor chip.

Thereafter, an obtained individual semiconductor chip is attached to a different support sheet or mounted on a printed circuit board, and therefore is transported and placed on a support sheet or a printed circuit board. During this transportation, the semiconductor chip is required not to be damaged or ruptured.

Meanwhile, Patent Literature 1 discloses a step of dicing a semiconductor substrate and a protective film to obtain a semiconductor device with a protective film (corresponding to a semiconductor chip in the present invention), and picking up the semiconductor device with a protective film (semiconductor chip) from a support sheet (see paragraph [0012] and the like of Patent Literature 1), and Examples in Patent Literature 1 disclose that even when a semiconductor wafer with a protective film was transported using a robot arm, no deformation occurred in a protective film-forming film attached to the semiconductor wafer (see paragraph [0160] and the like of Patent Literature 1).

### Citation List

### Patent Literature

Patent Literature 1: WO 2021/166991 A

### Summary of Invention

### Technical Problem

Meanwhile, in Patent Literature 1, a protective film-forming film is once produced, and the protective film-forming film produced in a sheet shape is attached to a semiconductor substrate to obtain a semiconductor wafer with a protective film.

In order to prevent damage accompanying transportation when an individual semiconductor chip obtained by dicing a semiconductor substrate is transported, provision of a semiconductor chip with a protective film is effective as described in Patent Literature 1, but the manufacturing method described in Patent Literature 1 cannot be said to be sufficient from the viewpoint of further simplifying an apparatus configuration and an operation procedure for manufacturing a semiconductor wafer with a protective film, and there is room for improvement.

It has been desired to provide a semiconductor chip with a protective film that can be manufactured by a simpler method.

Accordingly, an object of the present invention is to provide a semiconductor chip-manufacturing protective film-forming composition capable of easily forming a semiconductor chip-manufacturing protective film to be disposed on a semiconductor chip in order to provide, by a simpler method, a semiconductor chip with a protective film capable of protecting a semiconductor chip from damage accompanying transportation when an individual semiconductor chip obtained by dicing a semiconductor substrate is transported.

Further, an object of the present invention is to provide a semiconductor chip-manufacturing protective film-forming composition capable of forming such a semiconductor chip-manufacturing protective film such that the semiconductor chip-manufacturing protective film formed from the semiconductor chip-manufacturing protective film-forming composition can be easily dissolved in a removing liquid such as an alkaline removing liquid and can be easily removed from a semiconductor chip.

Still further, an object of the present invention is to provide a semiconductor chip-manufacturing protective film formed from the semiconductor chip-manufacturing protective film-forming composition, a semiconductor substrate or a semiconductor chip having the semiconductor chip-manufacturing protective film, and a method for manufacturing the semiconductor chip.

### Solution to Problem

As a result of intensive studies to solve the above problem, the present inventors have found that the above problem can be solved, thereby completing the present invention having the following gist.

That is, the present invention includes the following aspects.
[1] A semiconductor chip-manufacturing protective film-forming composition for preventing damage to a circuit surface or a back surface of a semiconductor substrate or a semiconductor chip,
   the semiconductor chip-manufacturing protective film-forming composition containing a polymer and a solvent, wherein
   the polymer is selected from a phenolic hydroxy group-containing polymer, a carboxy group-containing polymer, and a blocked carboxy group-containing polymer.
[2] The semiconductor chip-manufacturing protective film-forming composition according to [1], wherein the semiconductor chip-manufacturing protective film-forming composition forms a protective film that can be dissolved in an alkaline removing liquid, an acidic removing liquid, a neutral removing liquid, or an organic solvent.
[3] The semiconductor chip-manufacturing protective film-forming composition according to [1] or [2], wherein the semiconductor chip-manufacturing protective film-forming composition contains the polymer in an amount of 50 mass% or more with respect to the entire solid content in the composition.
[4] The semiconductor chip-manufacturing protective film-forming composition according to any one of [1] to [3], wherein when an individual semiconductor chip obtained by dicing a semiconductor substrate is transported, the semiconductor chip-manufacturing protective film is disposed on the semiconductor substrate in order to protect the semiconductor chip from damage accompanying the transportation.
[5] The semiconductor chip-manufacturing protective film-forming composition according to any one of [1] to [4], wherein the phenolic hydroxy group-containing polymer is selected from any of phenol novolac, naphthol novolac, a polyhydroxystyrene, a polyhydroxyphenyl (meth)acrylate, and a poly(N-hydroxyphenyl (meth)acrylamide).
[6] The semiconductor chip-manufacturing protective film-forming composition according to any one of [1] to [5], wherein the carboxy group-containing polymer is selected from any of a (meth)acrylic resin, polyvinylbenzoic acid, carboxymethyl cellulose, and a polyamic acid.
[7] The semiconductor chip-manufacturing protective film-forming composition according to [6], wherein the polyamic acid is a polyamic acid having a structural unit derived from a tetracarboxylic dianhydride compound (a) and a diamine compound having at least one carboxy group (b).
[8] The semiconductor chip-manufacturing protective film-forming composition according to any one of [1] to [7], wherein the semiconductor chip-manufacturing protective film-forming composition contains at least one of a crosslinking agent, an acid catalyst, and an additive.
[9] The semiconductor chip-manufacturing protective film-forming composition according to [8], wherein the crosslinking agent is selected from any of an aminoplast crosslinking agent, a phenoplast crosslinking agent, and a crosslinking agent containing an epoxy group.
[10] A semiconductor chip-manufacturing protective film, which is a baked product of a coating film formed of the semiconductor chip-manufacturing protective film-forming composition according to any one of [1] to [9].
[11] The semiconductor chip-manufacturing protective film according to [10], wherein the semiconductor chip-manufacturing protective film has a thickness of 1 to 10 µm.
[12] A semiconductor substrate including the semiconductor chip-manufacturing protective film according to [10] or [11].
[13] A semiconductor chip including the semiconductor chip-manufacturing protective film according to [10] or [11].
[14] A method for manufacturing a semiconductor chip, the method including a step of applying the semiconductor chip-manufacturing protective film-forming composition according to any one of [1] to [9] onto a semiconductor substrate, followed by baking to form a semiconductor chip-manufacturing protective film; a step of dicing the semiconductor substrate with the semiconductor chip-manufacturing protective film disposed thereon to obtain a semiconductor chip with the semiconductor chip-manufacturing protective film; and a step of transporting the semiconductor chip.
[15] The method for manufacturing a semiconductor chip according to [14], further including a step of removing the semiconductor chip-manufacturing protective film from the semiconductor chip by cleaning with an alkaline removing liquid, an acidic removing liquid, a neutral removing liquid, or an organic solvent.

### Advantageous Effects of Invention

According to the present invention, it is possible to provide a semiconductor chip-manufacturing protective film-forming composition capable of easily forming a semiconductor chip-manufacturing protective film to be disposed on a semiconductor chip in order to provide, by a simpler method, a semiconductor chip with a protective film capable of protecting a semiconductor chip from damage accompanying transportation when an individual semiconductor chip obtained by dicing a semiconductor substrate is transported.

Further, according to the present invention, it is possible to provide a semiconductor chip-manufacturing protective film-forming composition capable of forming such a semiconductor chip-manufacturing protective film such that the semiconductor chip-manufacturing protective film formed from the semiconductor chip-manufacturing protective film-forming composition can be easily dissolved in a removing liquid such as an alkaline removing liquid and can be easily removed from a semiconductor chip.

Still further, according to the present invention, it is possible to provide a semiconductor chip-manufacturing protective film formed from the semiconductor chip-manufacturing protective film-forming composition, a semiconductor substrate or a semiconductor chip having the semiconductor chip-manufacturing protective film, and a method for manufacturing the semiconductor chip.

### Brief Description of Drawings

Fig. 1 is a schematic cross-sectional view illustrating an example of a semiconductor substrate.
Fig. 2A is a schematic cross-sectional view illustrating an example of a semiconductor substrate having a coating film of a semiconductor chip-manufacturing protective film-forming composition.
Fig. 2B is a schematic cross-sectional view illustrating an example of a semiconductor substrate having a semiconductor chip-manufacturing protective film.
Fig. 3 is a schematic cross-sectional view illustrating another example of a semiconductor substrate having a semiconductor chip-manufacturing protective film.
Fig. 4 is a schematic cross-sectional view for explaining an example of a method for manufacturing a semiconductor chip of the present invention.
Fig. 5A is a schematic cross-sectional view for explaining an example of a method for manufacturing a semiconductor chip of the present invention.
Fig. 5B is a schematic cross-sectional view for explaining an example of a method for manufacturing a semiconductor chip of the present invention.
Fig. 6 is a schematic cross-sectional view for explaining an example of a method for manufacturing a semiconductor chip of the present invention.
Fig. 7A is a schematic cross-sectional view for explaining another example of a method for manufacturing a semiconductor chip of the present invention.
Fig. 7B is a schematic cross-sectional view for explaining another example of a method for manufacturing a semiconductor chip of the present invention.

### Description of Embodiments

### (Semiconductor chip-manufacturing protective film-forming composition)

The semiconductor chip-manufacturing protective film-forming composition of the present invention is a composition for forming a semiconductor chip-manufacturing protective film to be disposed on a semiconductor chip.

The semiconductor chip-manufacturing protective film-forming composition of the present invention is used for preventing damage to a circuit surface or a back surface of a semiconductor substrate or a semiconductor chip.

The semiconductor chip-manufacturing protective film-forming composition contains a polymer and a solvent.

The polymer is selected from a phenolic hydroxy group-containing polymer and a carboxy group-containing polymer. These polymers are soluble in a removing liquid such as an alkaline removing liquid. Therefore, the semiconductor chip-manufacturing protective film of the present invention formed of the semiconductor chip-manufacturing protective film-forming composition of the present invention is easily dissolved in a removing liquid such as an alkaline removing liquid (in the present description, the "removing liquid such as an alkaline removing liquid" is also simply referred to as a "removing liquid" or a "developer"), and can be easily removed from a semiconductor chip.

The semiconductor chip-manufacturing protective film of the present invention is disposed on a semiconductor chip, and as described above, when an individual semiconductor chip obtained by dicing a semiconductor substrate is transported, the semiconductor chip-manufacturing protective film can effectively protect the semiconductor chip from damage accompanying the transportation.

It is preferred that the phenolic hydroxy group-containing polymer is selected from any of phenol novolac, naphthol novolac, a polyhydroxystyrene, a polyhydroxyphenyl (meth)acrylate, and a poly(N-hydroxyphenyl

### (meth)acrylamide).

It is preferred that the carboxy group-containing polymer is selected from any of a (meth)acrylic resin, polyvinylbenzoic acid, carboxymethyl cellulose, and a polyamic acid.

Further, the semiconductor chip-manufacturing protective film-forming composition preferably contains the polymer in an amount of 50 mass% or more, more preferably 60 mass% or more, still more preferably 70 mass% or more, even more preferably 80 mass% or more, and particularly preferably 90 mass% or more with respect to the entire solid content in the composition.

### <Phenol novolac/naphthol novolac>

As the phenol novolac or the naphthol novolac (novolac resin), those conventionally used in a positive photosensitive material or the like can be used without limitation, and examples thereof include a resin obtained by polymerizing a phenol (naphthol is also included in the phenol) and an aldehyde in the presence of an acid catalyst.

Examples of the phenol include phenol; cresols such as o-cresol, m-cresol, and p-cresol; xylenols such as 2,3-xylenol, 2,4-xylenol, 2,5-xylenol, 2,6-xylenol, 3,4-xylenol, and 3,5-xylenol; alkylphenols such as o-ethylphenol, m-ethylphenol, p-ethylphenol, 2-isopropylphenol, 3-isopropylphenol, 4-isopropylphenol, o-butylphenol, m-butylphenol, p-butylphenol, and p-tertbutylphenol; trialkylphenols such as 2,3,5-trimethylphenol and 3,4,5-trimethylphenol; polyhydric phenols such as resorcinol, catechol, hydroquinone, hydroquinone monomethyl ether, pyrogallol, and phloroglucinol; alkyl polyhydric phenols such as alkyl resorcin, alkyl catechol, and alkyl hydroquinone (all alkyl groups have 1 to 4 carbon atoms); α-naphthol, β-naphthol, hydroxydiphenyl, and bisphenol A. These phenols may be used alone or two or more types thereof may be used in combination.

Examples of the aldehyde include formaldehyde, paraformaldehyde, furfural, benzaldehyde, nitrobenzaldehyde, and acetaldehyde. These aldehydes may be used alone or two or more types thereof may be used in combination.

Examples of the acid catalyst include inorganic acids such as hydrochloric acid, sulfuric acid, nitric acid, phosphoric acid, and phosphorous acid; organic acids such as formic acid, oxalic acid, acetic acid, diethyl sulfuric acid, and p-toluenesulfonic acid; and metal salts such as zinc acetate.

In the present application, a naphthol cresol novolac obtained by polymerizing α-naphthol or β-naphthol may be used.

### <Polyhydroxystyrene>

The polyhydroxystyrene include polyhydroxystyrene and a polyhydroxystyrene derivative.

Examples of the polyhydroxystyrene or the polyhydroxystyrene derivative include poly-o-hydroxystyrene, poly-m-hydroxystyrene, poly-p-hydroxystyrene, poly-α-methyl-o-hydroxystyrene, poly-α-methyl-m-hydroxystyrene, and poly-α-methyl-p-hydroxystyrene.

The polyhydroxystyrene or the polyhydroxystyrene derivative may be a homopolymer of hydroxystyrene which may have a substituent, or may be a copolymer obtained by copolymerizing hydroxystyrene which may have a substituent with another compound. Examples of another compound at this time include (meth)acrylic acid and a (meth)acrylic acid derivative described later, acrylonitrile, methacrylonitrile, styrene, styrene derivatives such as α-methylstyrene, p-methylstyrene, o-methylstyrene, p-methoxystyrene, and p-chlorostyrene.

The polyhydroxystyrene according to the present application can be obtained by polymerizing hydroxystyrene which may have a substituent, and preferably has, for example, the following unit structure.

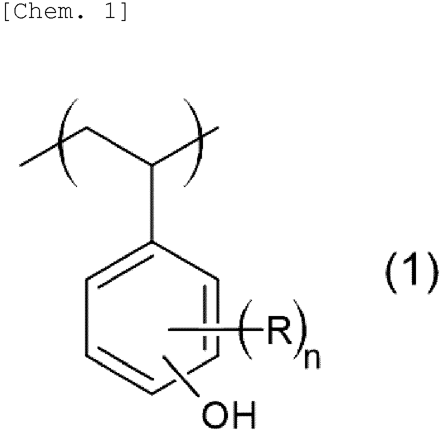

In formula (1), R represents a halogen atom, a carboxy group, a nitro group, a cyano group, a methylenedioxy group, an acetoxy group, a methylthio group, an amino group, or an alkoxy group having 1 to 9 carbon atoms. n represents an integer of 0 to 4. When n is 2 or more, n number of R's may be identical or different.

Examples of the halogen atom include a fluorine atom, a chlorine atom, a bromine atom, and an iodine atom.

Examples of the alkoxy group having 1 to 9 carbon atoms include a methoxy group, an ethoxy group, a n-propoxy group, an i-propoxy group, a n-butoxy group, an i-butoxy group, an s-butoxy group, a t-butoxy group, a n-pentoxy group, a 1-methyl-n-butoxy group, a 2-methyl-n-butoxy group, a 3-methyl-n-butoxy group, a 1,1-dimethyl-n-propoxy group, a 1,2-dimethyl-n-propoxy group, a 2,2-dimethyl-n-propoxy group, a 1-ethyl-n-propoxy group, a n-hexyloxy group, a 1-methyl-n-pentyloxy group, a 2-methyl-n-pentyloxy group, a 3-methyl-n-pentyloxy group, a 4-methyl-n-pentyloxy group, a 1,1-dimethyl-n-butoxy group, a 1,2-dimethyl-n-butoxy group, a 1,3-dimethyl-n-butoxy group, a 2,2-dimethyl-n-butoxy group, a 2,3-dimethyl-n-butoxy group, a 3,3-dimethyl-n-butoxy group, a 1-ethyl-n-butoxy group, a 2-ethyl-n-butoxy group, a 1,1,2-trimethyl-n-propoxy group, a 1,2,2-trimethyl-n-propoxy group, a 1-ethyl-1-methyl-n-propoxy group, a 1-ethyl-2-methyl-n-propoxy group, a n-heptyloxy group, a n-octyloxy group, and a n-nonyloxy group.

### <Polyhydroxyphenyl (meth)acrylate>

The polyhydroxyphenyl (meth)acrylate include polyhydroxyphenyl (meth)acrylate and a polyhydroxyphenyl (meth)acrylate derivative.

The polyhydroxyphenyl (meth)acrylate or the polyhydroxyphenyl (meth)acrylate derivative may be a homopolymer of hydroxyphenyl (meth)acrylate which may have a substituent, or may be a copolymer obtained by copolymerizing hydroxyphenyl (meth)acrylate which may have a substituent with another compound as described above.

The polyhydroxyphenyl (meth)acrylate according to the present application is obtained by polymerizing hydroxyphenyl (meth)acrylate which may have a substituent, and preferably has, for example, the following unit structure.

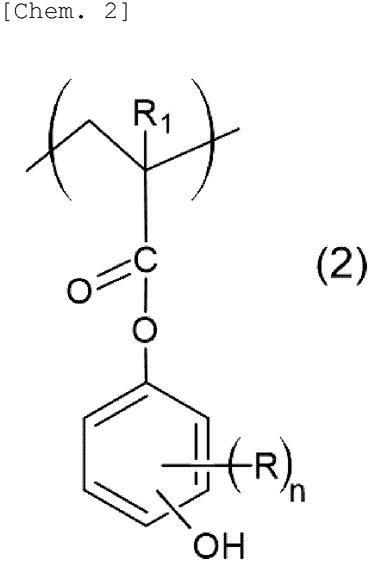

In formula (2), R₁ represents a hydrogen atom or a methyl group. R represents a halogen atom, a carboxy group, a nitro group, a cyano group, a methylenedioxy group, an acetoxy group, a methylthio group, an amino group, or an alkoxy group having 1 to 9 carbon atoms. n represents an integer of 0 to 4. When n is 2 or more, n number of R's may be identical or different.

### <Poly(N-hydroxyphenyl (meth)acrylamide)>

The poly(N-hydroxyphenyl (meth)acrylamide) include poly(N-hydroxyphenyl (meth)acrylamide) and a poly(N-hydroxyphenyl (meth)acrylamide) derivative.

The poly(N-hydroxyphenyl (meth)acrylamide) or the poly(N-hydroxyphenyl (meth)acrylamide) derivative may be a homopolymer of N-hydroxyphenyl (meth)acrylamide which may have a substituent, or may be a copolymer obtained by copolymerizing N-hydroxyphenyl (meth)acrylamide which may have a substituent with another compound as described above.

The poly(N-hydroxyphenyl (meth)acrylamide) according to the present application is obtained by polymerizing N-hydroxyphenyl (meth)acrylamide which may have a substituent, and preferably has, for example, the following unit structure.

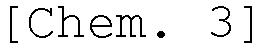

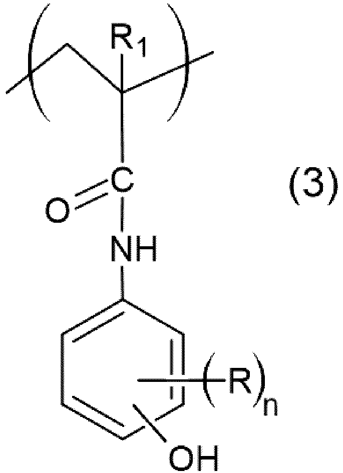

In formula (3), R₁ represents a hydrogen atom or a methyl group. R represents a halogen atom, a carboxy group, a nitro group, a cyano group, a methylenedioxy group, an acetoxy group, a methylthio group, an amino group, or an alkoxy group having 1 to 9 carbon atoms. n represents an integer of 0 to 4. When n is 2 or more, n number of R's may be identical or different.

### <(Meth)acrylic resin>

The (meth)acrylic resin according to the present application is a (meth)acrylic resin having a carboxy group.

As the (meth)acrylic resin according to the present application, those conventionally used in a positive photosensitive material and the like can be used without limitation, and examples thereof include a resin obtained by polymerizing a polymerizable monomer having a (meth)acrylic group in the presence of a radical polymerization initiator.

The carboxy group may be a blocked carboxy group. Examples of the blocked carboxy group include a carboxy group protected by a vinyl ether.

The (meth)acrylic resin having a carboxy group may be, for example, a homopolymer of a polymerizable monomer (I) having a carboxyl group and a (meth)acrylic group, or a copolymer obtained by copolymerizing a polymerizable monomer (I) having a carboxyl group and a (meth)acrylic group with a polymerizable monomer (II) having a (meth)acrylic group shown below.

Examples of the polymerizable monomer (I) having a carboxyl group and a (meth)acrylic group include (meth)acrylic acid, α-bromo(meth)acrylic acid, α-chloro(meth)acrylic acid, β-furyl(meth)acrylic acid, and β-styryl(meth)acrylic acid.

Examples of the polymerizable monomer (II) having a (meth)acrylic group include alkyl (meth)acrylates such as methyl (meth)acrylate, ethyl (meth)acrylate, propyl (meth)acrylate, butyl (meth)acrylate, pentyl (meth)acrylate, hexyl (meth)acrylate, heptyl (meth)acrylate, octyl (meth)acrylate, 2-ethylhexyl (meth)acrylate, nonyl (meth)acrylate, decyl (meth)acrylate, undecyl (meth)acrylate, dodecyl (meth)acrylate, trifluoroethyl (meth)acrylate, and tetrafluoropropyl (meth)acrylate; acrylamides such as diacetone acrylamide; tetrahydrofurfuryl (meth)acrylate, dialkylaminoethyl (meth)acrylate, and glycidyl (meth)acrylate.

As the polymerizable monomer (I) or the polymerizable monomer (II) applied in combination with the polymerizable monomer (I), two or more types may be used in combination.

Examples of the radical polymerization initiator include organic peroxides such as benzoyl peroxide, dicumyl peroxide, and dibutyl peroxide; and azobis compounds such as azobisisobutyronitrile and azobisvaleronitrile.

In addition, the (meth)acrylic resin according to the present application may be a copolymer obtained by copolymerizing the polymerizable monomer (I) or the polymerizable monomer (I) and the polymerizable monomer (II) together with another compound.

For example, it may be a copolymer obtained by adding one type or two or more types of styrene, polymerizable styrene derivatives substituted at an α-position or on an aromatic ring such as vinyltoluene and α-methylstyrene; acrylonitrile, esters of a vinyl alcohol such as vinyl-n-butyl ether; maleic acid, maleic anhydride, maleic acid monoesters such as monomethyl maleate, monoethyl maleate, and monoisopropyl maleate; and polymerizable monomers such as fumaric acid, cinnamic acid, α-cyanosilicic acid, itaconic acid, and crotonic acid to the polymerizable monomer (I) or the polymerizable monomer (I) and the polymerizable monomer (II).

In the present description, "(meth)acrylic" means both "acrylic" and "methacrylic".

### <Polyvinylbenzoic acid>

The polyvinylbenzoic acid of the present application is obtained by, for example, polymerizing 4-vinylbenzoic acid shown below by a known method.

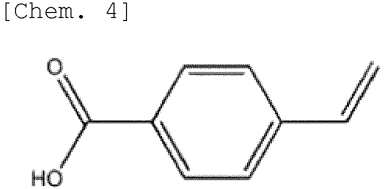

### <Carboxymethyl cellulose>

The carboxymethyl cellulose of the present application has a structure shown below.

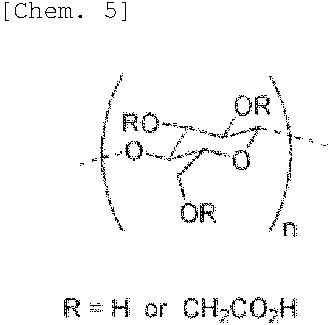

In the formula, n represents the number of repeat units.

### <Polyamic acid>

The semiconductor chip-manufacturing protective film-forming composition of the present invention may contain a carboxy group-containing polymer which is a polyamic acid having a structural unit derived from a tetracarboxylic dianhydride compound (a) and a diamine compound having at least one carboxy group (b). The polymer may be a polyamic acid having a structural unit derived from a tetracarboxylic dianhydride compound (a) and a diamine compound having at least one carboxy group (b), and a structural unit derived from a tetracarboxylic dianhydride compound (a) and a diamine compound (c) different from (b).

The diamine compound (c) may be a diamine compound having no carboxy group.

Examples of the polyamic acid contained in the semiconductor chip-manufacturing protective film-forming composition of the present invention include the following polyamic acids (29) to (41) (in formulae, p1, p2, p3, and p4 represent the proportion of each structure in the polyamic acid). Here, (29) to (36) are polyamic acids produced from one type of tetracarboxylic dianhydride compound and two types of diamine compounds, (37) and (38) are polyamic acids produced from two types of tetracarboxylic dianhydride compounds and one type of diamine compound, (39) is a polyamic acid produced from two types of tetracarboxylic dianhydride compounds and two types of diamine compounds, and (40) and (41) are polyamic acids produced from one type of tetracarboxylic dianhydride compound and one type of diamine compound. 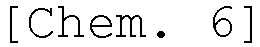 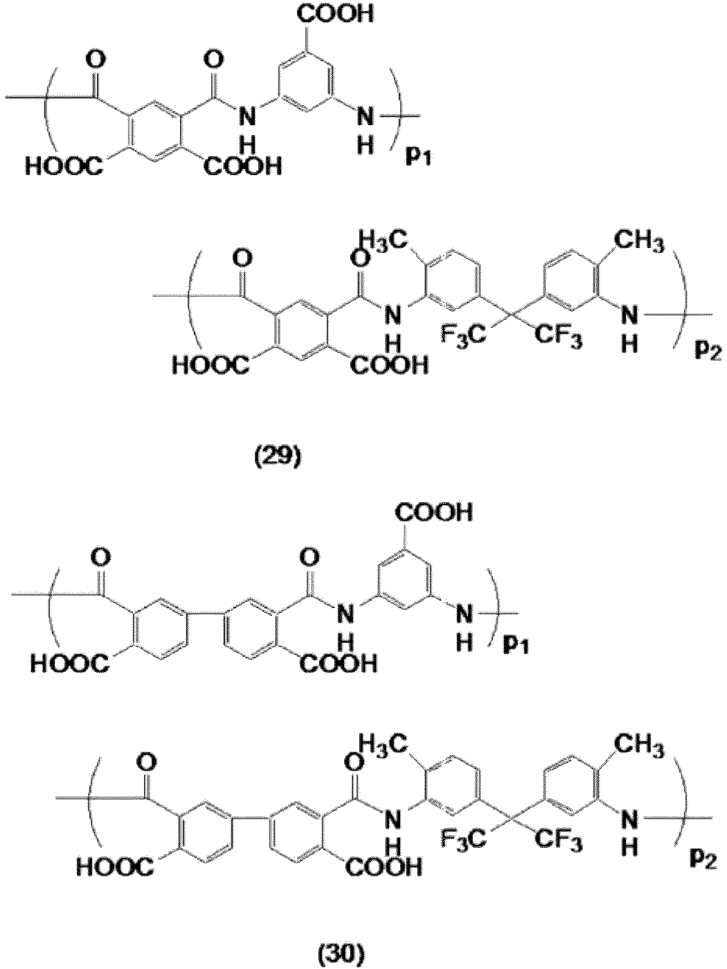 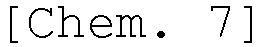 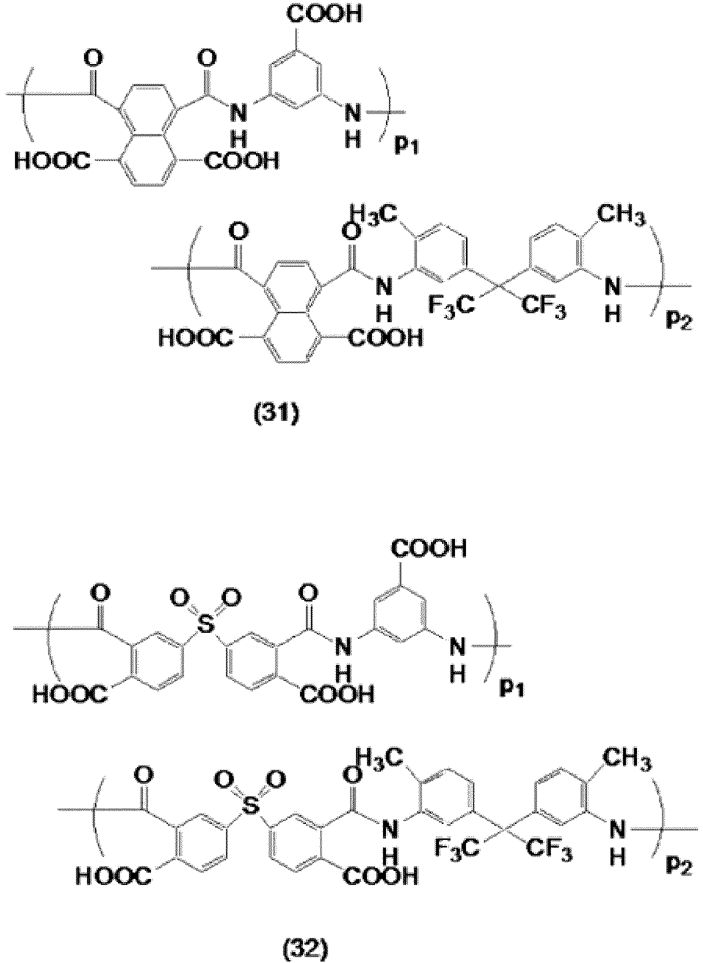 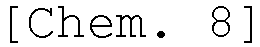 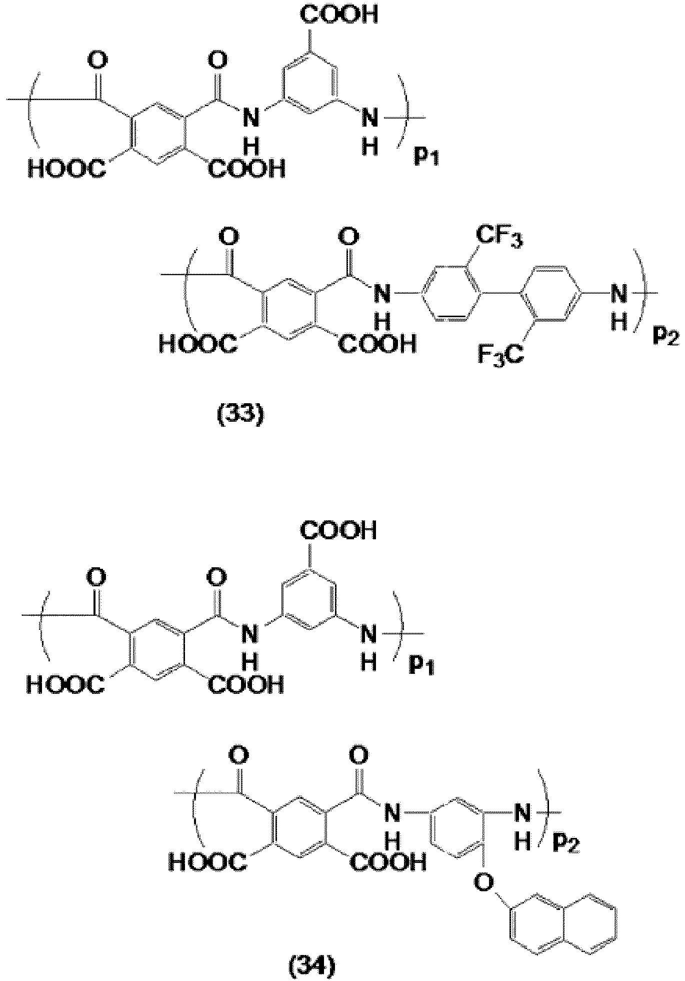 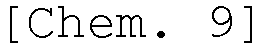 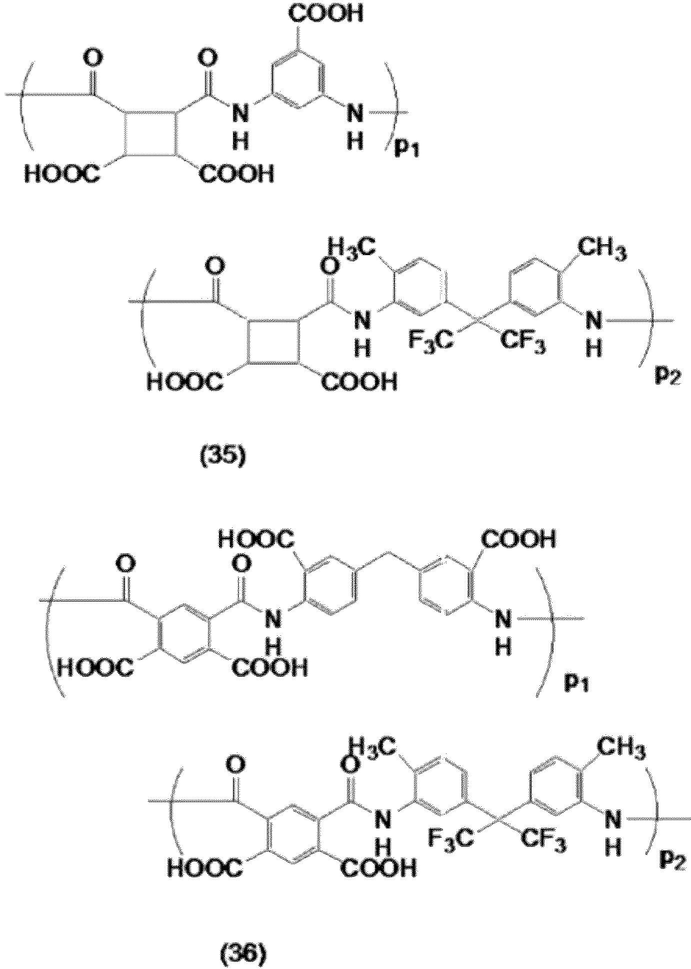 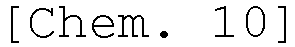 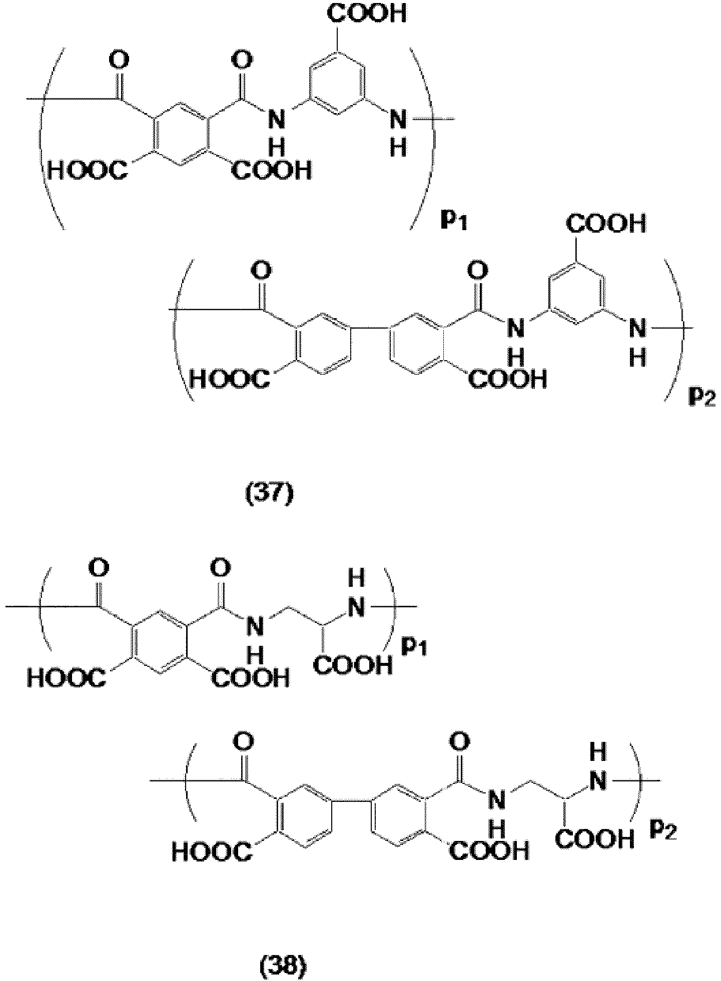 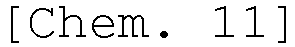 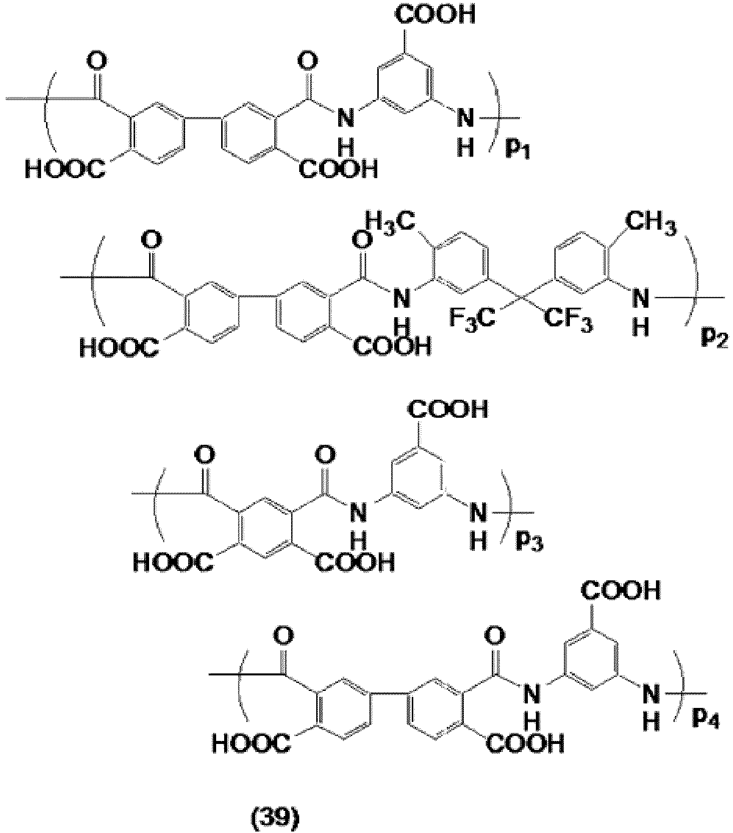 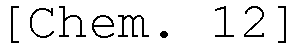 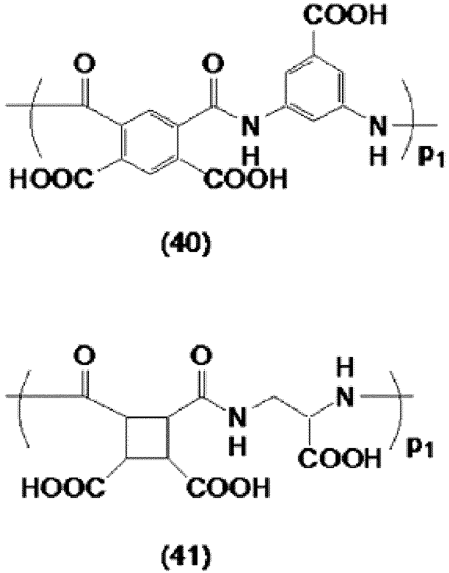 The contents of WO 2018/159665 A are incorporated herein to the same extent as all the contents are specified.

The weight average molecular weight of the polymer according to the present application is, for example, 1,000 to 100,000 or 1,000 to 50,000, and preferably 2,000 to 50,000 in terms of polystyrene as measured by gel permeation chromatography (GPC). When the weight average molecular weight is 1,000 or more, coatability can be improved, and when the weight average molecular weight is 100,000 or less, the solubility of the semiconductor chip-manufacturing protective film to be formed in an alkaline removing liquid can be sufficiently ensured.

### <Solvent>

The semiconductor chip-manufacturing protective film-forming composition of the present invention can be easily prepared by uniformly mixing the respective components, and is dissolved in an appropriate solvent and used in a solution state. As such a solvent, ethylene glycol monomethyl ether, ethylene glycol monoethyl ether, methyl cellosolve acetate, ethyl cellosolve acetate, diethylene glycol monomethyl ether, diethylene glycol monoethyl ether, propylene glycol, propylene glycol monomethyl ether, propylene glycol monomethyl ether acetate, propylene glycol propyl ether acetate, toluene, xylene, methyl ethyl ketone, cyclopentanone, cyclohexanone, ethyl 2-hydroxypropionate, ethyl 2-hydroxy-2-methylpropionate, ethyl ethoxyacetate, ethyl hydroxyacetate, methyl 2-hydroxy-3-methylbutanoate, methyl 3-methoxypropionate, ethyl 3-methoxypropionate, ethyl 3-ethoxypropionate, methyl 3-ethoxypropionate, methyl pyruvate, ethyl pyruvate, ethyl acetate, butyl acetate, ethyl lactate, butyl lactate, N,N-dimethylformamide, N,N-dimethylacetamide, N-methylpyrrolidone, or the like can be used. These solvents may be used alone or two or more types thereof may be used in combination. Further, a high-boiling-point solvent such as propylene glycol monobutyl ether and propylene glycol monobutyl ether acetate can be mixed and used.

The semiconductor chip-manufacturing protective film-forming composition solution thus prepared is preferably filtered using a filter having a pore size of about 0.2 µm or the like and then used. The semiconductor chip-manufacturing protective film-forming composition solution thus prepared is also excellent in long-term storage stability at room temperature.

The proportion of the solid content in the semiconductor chip-manufacturing protective film-forming composition of the present invention is not particularly limited as long as the components are uniformly dissolved, and is, for example, 0.5 to 50 mass%, or, for example, 1 to 30 mass%. Here, the solid content means a component left after removal of the solvent component from all the components of the semiconductor chip-manufacturing protective film-forming composition.

The semiconductor chip-manufacturing protective film-forming composition of the present invention preferably contains at least one of a crosslinking agent, an acid catalyst, and an additive.

### <Crosslinking agent>

The crosslinking agent is preferably any of an aminoplast crosslinking agent, a phenoplast crosslinking agent, and a crosslinking agent containing an epoxy group.

### <<Aminoplast crosslinking agent>>

The aminoplast crosslinking agent is an addition condensate of a compound having an amino group, such as melamine or guanamine, and formaldehyde.

### <<Phenoplast crosslinking agent>>

The phenoplast crosslinking agent is an addition condensate of a compound having a phenolic hydroxy group and formaldehyde.

### <<Crosslinking agent containing epoxy group>>

The crosslinking agent containing an epoxy group may contain a compound having at least two epoxy groups. Such a compound is not particularly limited as long as it is a compound having epoxy groups. Examples of the compound include tris(2,3-epoxypropyl) isocyanurate, 1,4-butanediol diglycidyl ether, 1,2-epoxy-4-(epoxyethyl)cyclohexane, glycerol triglycidyl ether, diethylene glycol diglycidyl ether, 2,6-diglycidyl phenyl glycidyl ether, 1,1,3-tris[p-(2,3-epoxypropoxy)phenyl]propane, 1,2-cyclohexanedicarboxylic acid diglycidyl ester, 4,4'-methylenebis(N,N-diglycidylaniline), 3,4-epoxycyclohexylmethyl-3,4-epoxycyclohexanecarboxylate, trimethylolethane triglycidyl ether, bisphenol-A-diglycidyl ether, and pentaerythritol polyglycidyl ether.

Examples of the compound having at least two epoxy groups include YH-434 and YH434L (trade names, manufactured by Nippon Steel Chemical & Materials Co., Ltd.) as epoxy resins having an amino group, EPOLEAD GT-401, GT-403, GT-301, GT-302, CELLOXIDE 2021, and CELLOXIDE 3000 (trade names, manufactured by Daicel Chemical Industries, Ltd.) as epoxy resins having a cyclohexene oxide structure, EPICOAT 1001, 1002, 1003, 1004, 1007, 1009, 1010, and 828 (trade names, manufactured by Yuka Shell Epoxy KK.) and the like as bisphenol A-type epoxy resins, EPICOAT 807 (trade name, manufactured by Yuka Shell Epoxy KK.) and the like as a bisphenol F-type epoxy resin, EPICOAT 152 and 154 (trade names manufactured by Yuka Shell Epoxy KK.), EPPN201 and 202 (trade names, manufactured by Nippon Kayaku Co., Ltd.) and the like as phenol novolac-type epoxy resins, EOCN-102, EOCN-103S, EOCN-104S, EOCN-1020, EOCN-1025, and EOCN-1027 (trade names, manufactured by Nippon Kayaku Co., Ltd.), EPICOAT 180S75 (trade name, manufactured by Yuka Shell Epoxy KK.), and the like as cresol novolac-type epoxy resins, DENACOL EX-252 (trade name, manufactured by Nagase ChemteX Corporation), CY175, CY177, and CY179 (trade names, manufactured by CIBA-GEIGY AG), Araldite CY-182, CY-192, and CY-184 (trade names, manufactured by CIBA-GEIGY AG), EPICLON 200 and 400 (trade names, manufactured by Dainippon Ink, Inc.) EPICOAT 871 and 872 (trade names, manufactured by Yuka Shell Epoxy KK.) ED-5661 and ED-5662 (trade names, manufactured by Celanese Coatings Co.), and the like as alicyclic epoxy resins, and DENACOL EX-611, EX-612, EX-614, EX-622, EX-411, EX-512, EX-522, EX-421, EX-313, EX-314, and EX-321 (trade names, manufactured by Nagase ChemteX Corporation), and the like as aliphatic polyglycidyl ethers.

The content of the crosslinking agent is, for example, 5 to 70 parts by mass or 10 to 60 parts by mass, and preferably 10 to 30 parts by mass with respect to 100 parts by mass of the polymer. When the content of the crosslinking agent is less than 5 parts by mass, the degree of curing of the semiconductor chip-manufacturing protective film may be insufficient. When the content exceeds 70 parts by mass, sufficient solubility in a removing liquid such as an alkaline removing liquid cannot be obtained.

Preferred embodiments of the crosslinking agent include, for example, compounds having two or more of the following structures.

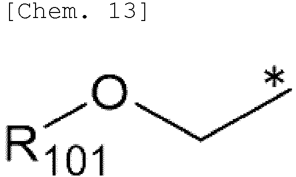

In the structure, R₁₀₁ represents a hydrogen atom, an alkyl group having 1 to 4 carbon atoms, or an alkoxyalkyl group having 2 to 6 carbon atoms. * represents a bond.

The bond is bonded to, for example, a nitrogen atom, a carbon atom included in an aromatic hydrocarbon ring, or the like.

As R₁₀₁, a hydrogen atom, a methyl group, an ethyl group, or a group represented by the following structure is preferred.

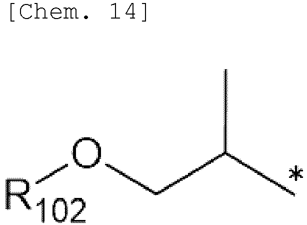

In the structure, R₁₀₂ represents a hydrogen atom, a methyl group, or an ethyl group. * represents a bond.

The crosslinking agent is preferably a melamine compound, a guanamine compound, a glycoluril compound, a urea compound, or a compound having a phenolic hydroxy group. One type of these can be used alone or two or more types thereof can be used in combination.

Examples of the melamine compound include hexamethylolmelamine, hexamethoxymethylmelamine, a compound in which 1 to 6 methylol groups of hexamethylolmelamine are methoxymethylated or a mixture thereof, hexamethoxyethylmelamine, hexaacyloxymethylmelamine, and a compound in which 1 to 6 methylol groups of hexamethylolmelamine are acyloxymethylated or a mixture thereof.

Examples of the guanamine compound include tetramethylolguanamine, tetramethoxymethylguanamine, a compound in which 1 to 4 methylol groups of tetramethylolguanamine are methoxymethylated or a mixture thereof, tetramethoxyethylguanamine, tetraacyloxyguanamine, and a compound in which 1 to 4 methylol groups of tetramethylolguanamine are acyloxymethylated or a mixture thereof.

Examples of the glycoluril compound include tetramethylol glycoluril, tetramethoxy glycoluril, tetramethoxymethyl glycoluril, a compound in which 1 to 4 methylol groups of tetramethylol glycoluril are methoxymethylated or a mixture thereof, and a compound in which 1 to 4 methylol groups of tetramethylol glycoluril are acyloxymethylated or a mixture thereof.

The glycoluril compound may be, for example, a glycoluril derivative represented by formula (1E) below.

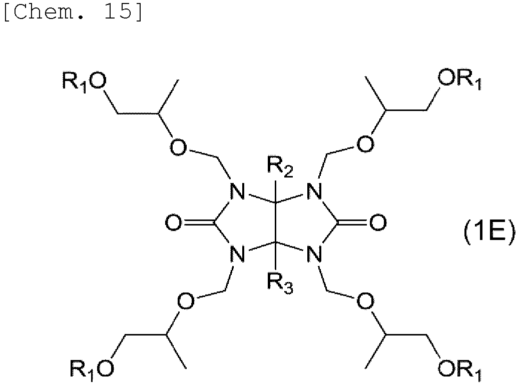

In formula (1E), four R₁'s each independently represent a methyl group or an ethyl group, and R₂ and R₃ each independently represent a hydrogen atom, an alkyl group having 1 to 4 carbon atoms, or a phenyl group.

Examples of the glycoluril derivative represented by formula (1E) include compounds represented by formulae (1E-1) to (1E-6) below.

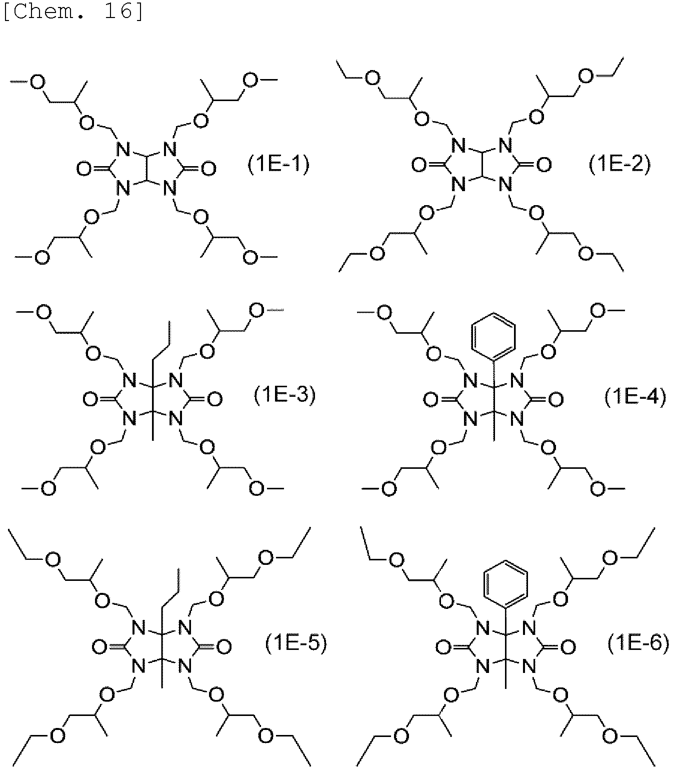

The glycoluril derivative represented by formula (1E) is obtained by, for example, allowing a glycoluril derivative represented by formula (2E) below to react with at least one type of compound represented by formula (3d) below.

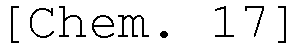

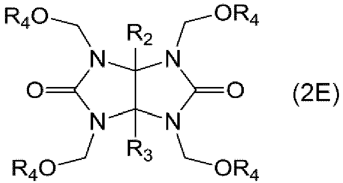

In formula (2E), R₂ and R₃ each independently represent a hydrogen atom, an alkyl group having 1 to 4 carbon atoms, or a phenyl group, and R₄'s each independently represent an alkyl group having 1 to 4 carbon atoms.

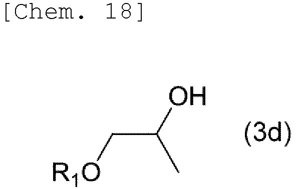

In formula (3d), R₁ represents a methyl group or an ethyl group.

Examples of the glycoluril derivative represented by formula (2E) include compounds represented by formulae (2E-1) to (2E-4) below. Further, examples of the compound represented by formula (3d) include compounds represented by formulae (3d-1) and (3d-2) below.

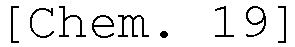

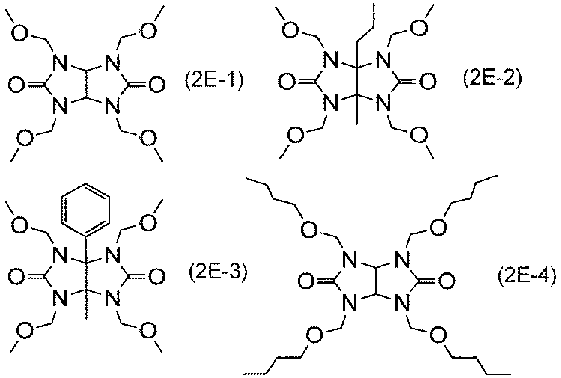

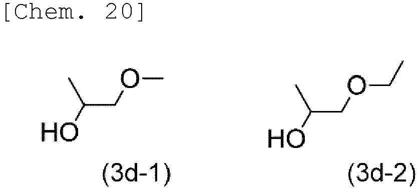

Examples of the urea compound include tetramethylol urea, tetramethoxy methyl urea, a compound in which 1 to 4 methylol groups of tetramethylol urea are methoxymethylated or a mixture thereof, and tetramethoxy ethyl urea.

Examples of the compound having a phenolic hydroxy group include a compound represented by formula (G-1) or formula (G-2) below.

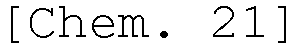

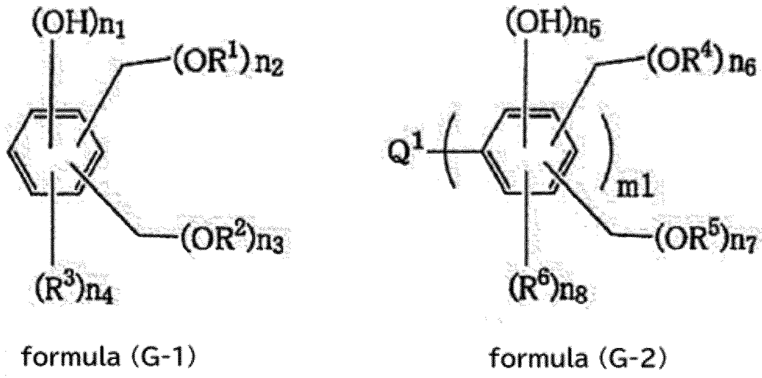

In formula (G-1) and formula (G-2), Q¹ represents a single bond or an m1-valent organic group.

R¹ and R⁴ each represent an alkyl group having 2 to 10 carbon atoms or an alkyl group having 2 to 10 carbon atoms and having an alkoxy group having 1 to 10 carbon atoms.

R² and R⁵ each represent a hydrogen atom or a methyl group.

R³ and R⁶ each represent an alkyl group having 1 to 10 carbon atoms or an aryl group having 6 to 40 carbon atoms.

n₁ represents an integer that meets 1 ≤ n₁ ≤ 3, n₂ represents an integer that meets 2 ≤ n₂ ≤ 5, n₃ represents an integer that meets 0 ≤ n₃ ≤ 3, n₄ represents an integer that meets 0 ≤ n₄ ≤ 3, and an integer that meets 3 ≤ (n₁ + n₂ + n₃ + n₄) ≤ 6.

n₅ represents an integer that meets 1 ≤ n₅ ≤ 3, n₆ represents an integer that meets 1 ≤ n₆ ≤ 4, n₇ represents an integer that meets 0 ≤ n₇ ≤ 3, n₈ represents an integer that meets 0 ≤ n₈ ≤ 3, and an integer that meets 2 ≤ (n₅ + n₆ + n₇ + n₈) ≤ 5.

m1 represents an integer of 2 to 10.

Examples of the compound having a phenolic hydroxy group include a compound represented by formula (G-3) or formula (G-4) below.

The compound represented by formula (G-1) or formula (G-2) may be obtained by a reaction of a compound represented by formula (G-3) or formula (G-4) below with a hydroxyl group-containing ether compound or an alcohol having 2 to 10 carbon atoms.

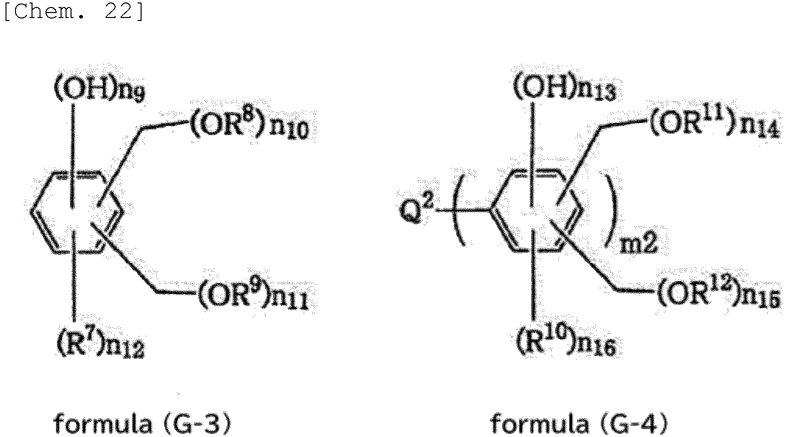

In formula (G-3) and formula (G-4), Q² represents a single bond or an m2-valent organic group.

R⁸, R⁹, R¹¹, and R¹² each represent a hydrogen atom or a methyl group.

R⁷ and R¹⁰ each represent an alkyl group having 1 to 10 carbon atoms or an aryl group having 6 to 40 carbon atoms.

n₉ represents an integer that meets 1 ≤ n₉ ≤ **3,** n₁₀ represents an integer that meets 2 ≤ n₁₀ ≤ **5,** n₁₁ represents an integer that meets 0 ≤ n₁₁ ≤ **3,** and n₁₂ represents an integer that meets 0 ≤ n₁₂ ≤ **3,** and an integer that meets 3 ≤ (n₉ + n₁₀ + n₁₁ + n₁₂) ≤ **6.**

n₁₃ represents an integer that meets 1 ≤ n₁₃ ≤ **3,** n₁₄ represents an integer that meets 1 ≤ n₁₄ ≤ **4,** n₁₅ represents an integer that meets 0 ≤ n₁₅ ≤ **3,** and n₁₆ represents an integer that meets 0 ≤ n₁₆ ≤ **3,** and an integer that meets 2 ≤ (n₁₃ + n₁₄ + n₁₅ + n₁₆) ≤ 5.

m2 represents an integer of 2 to **10.**

Examples of the m2-valent organic group in Q² include an m2-valent organic group having 1 to 4 carbon atoms.

Examples of the compound represented by formula (G-1) or formula (G-2) include the following compounds.

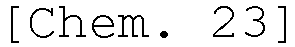

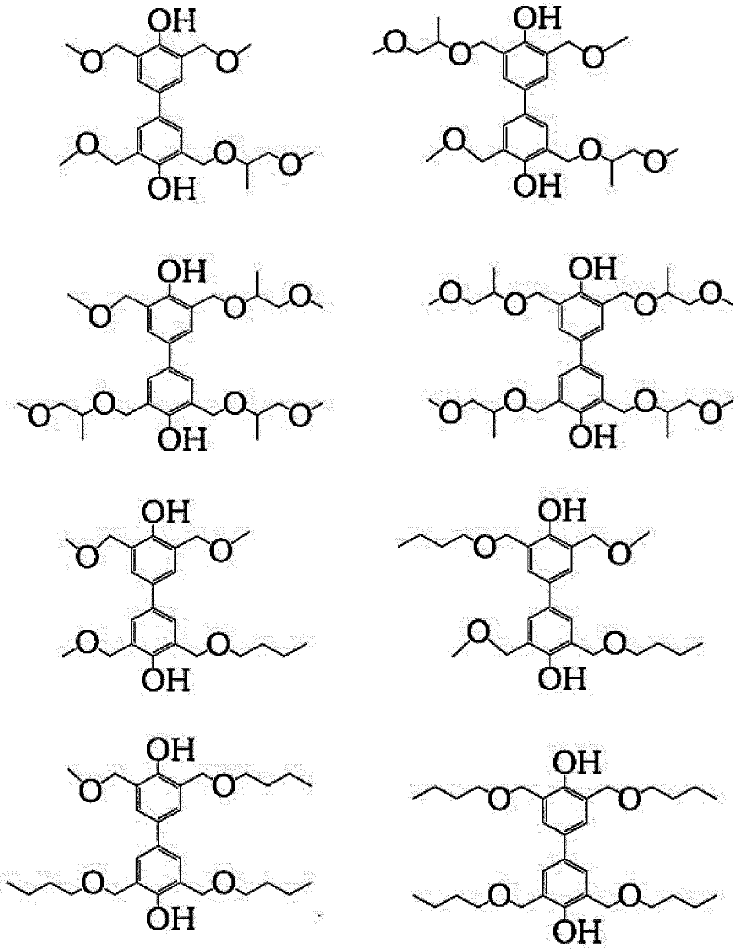

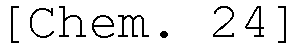

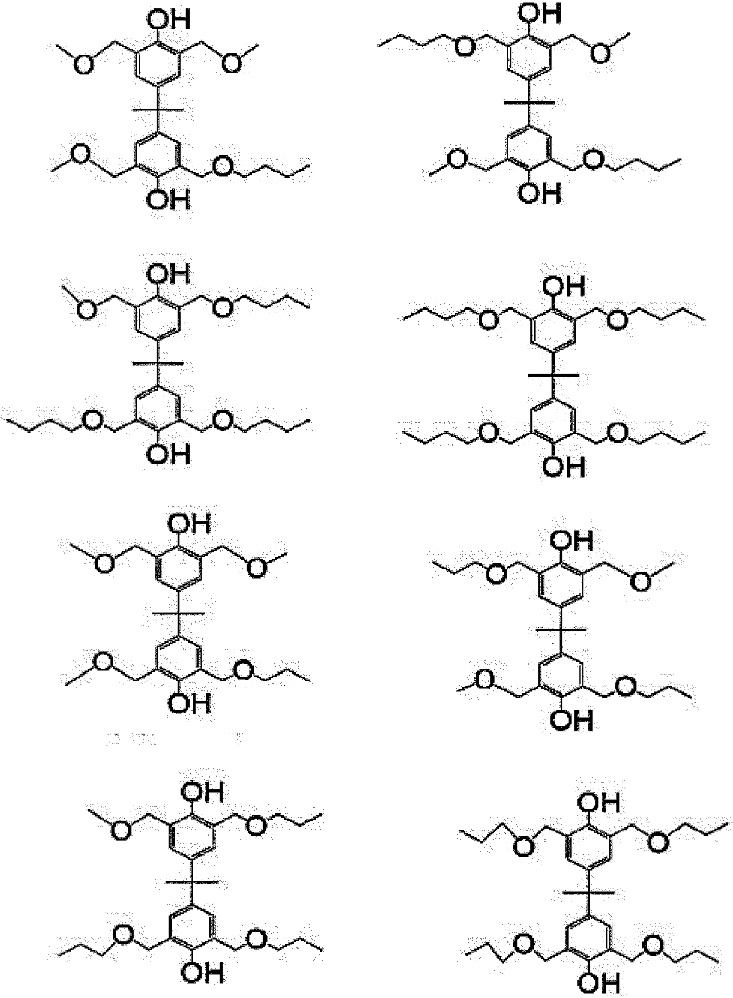

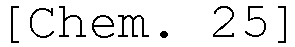

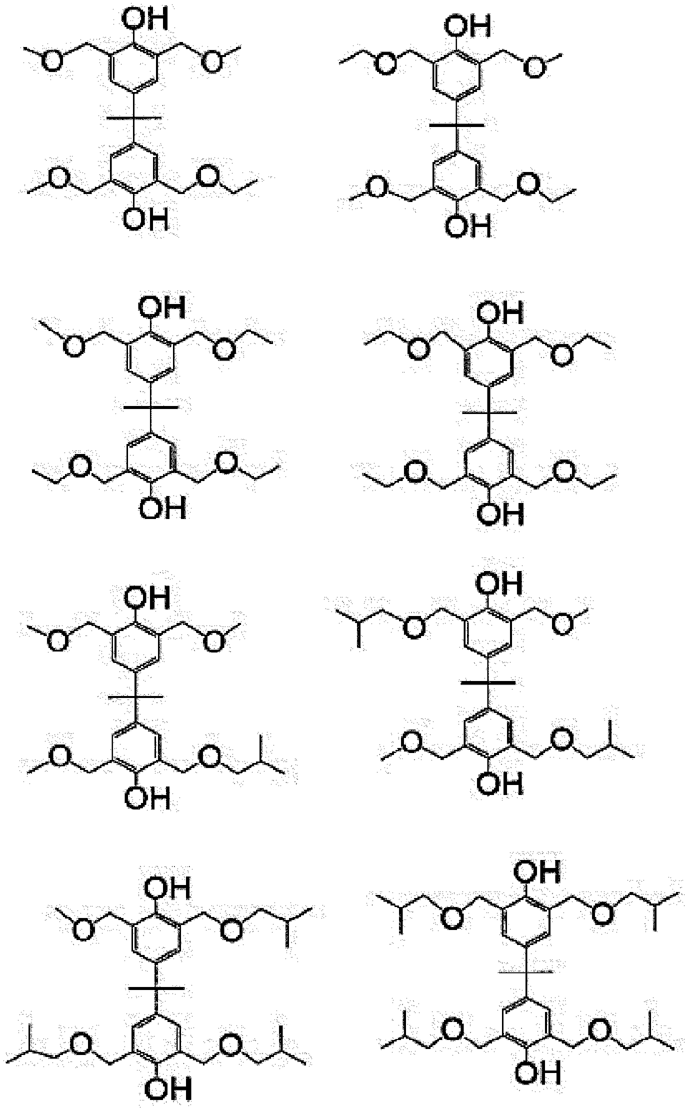

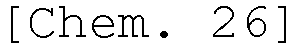

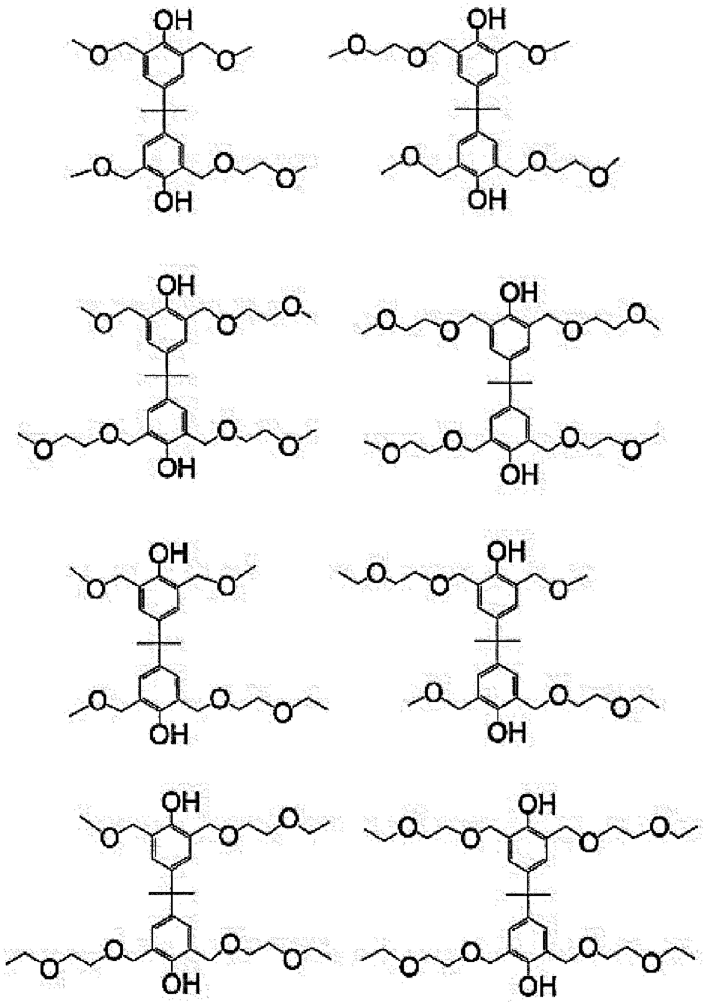

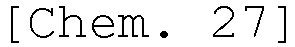

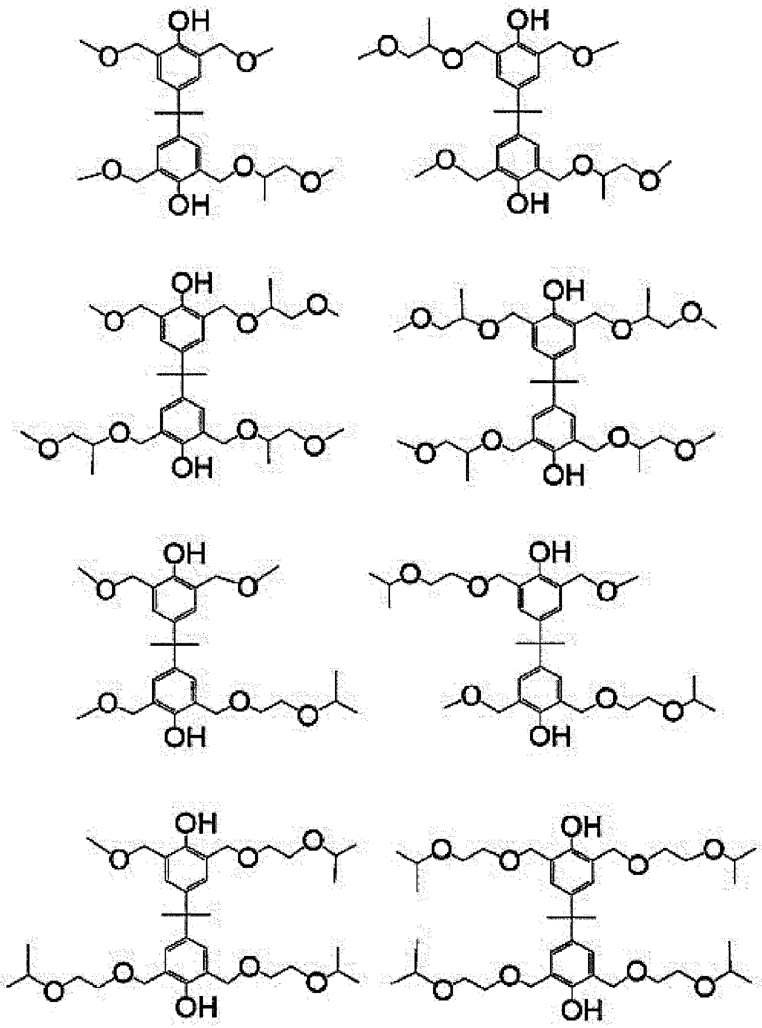

Examples of the compound represented by formula (G-3) or formula (G-4) include the following compounds.

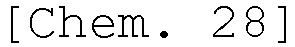

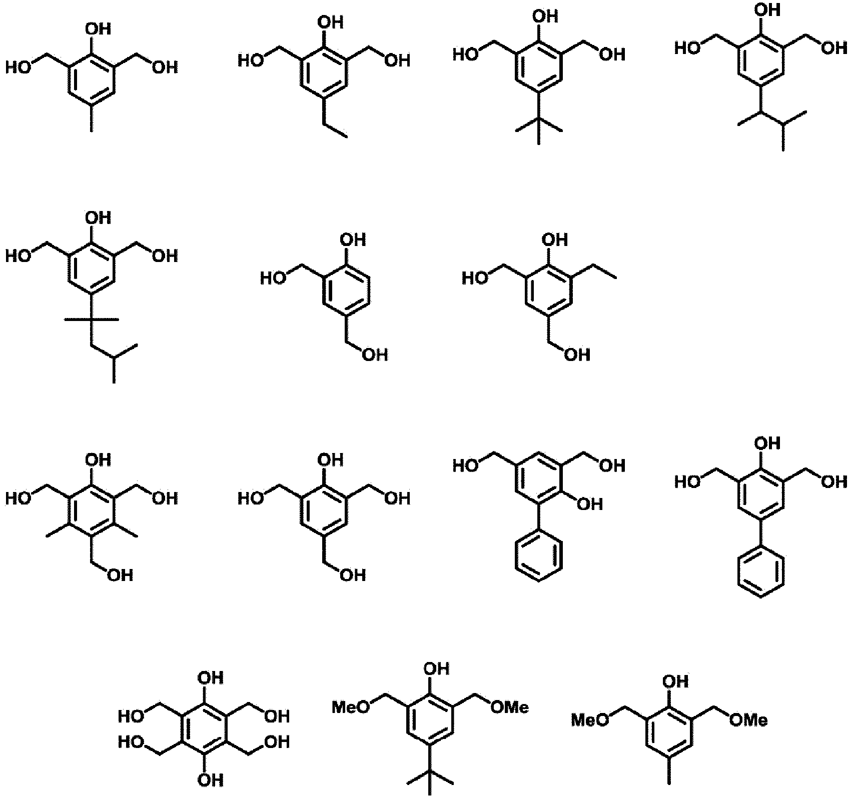

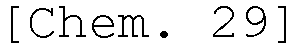

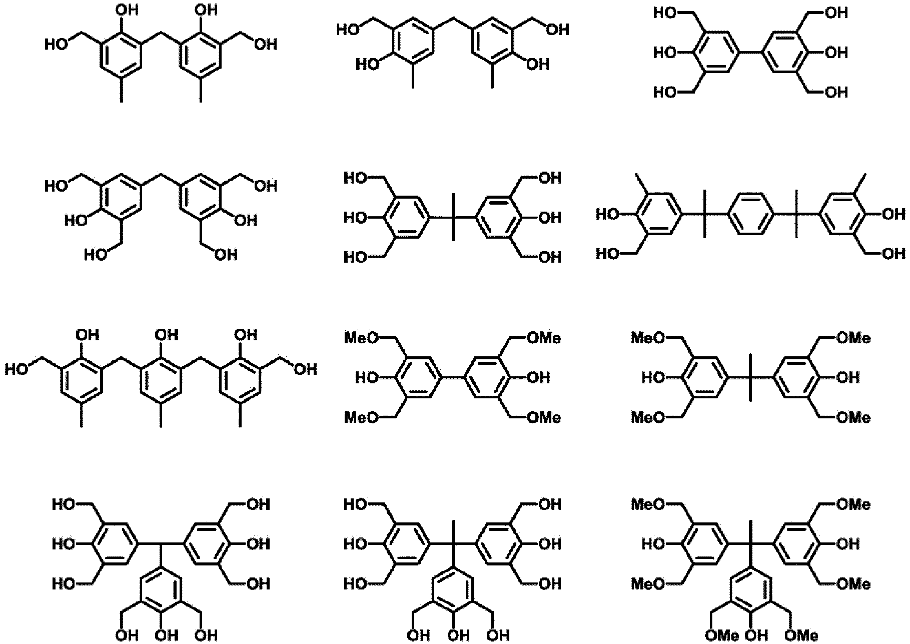

The compounds are available as products of Asahi Organic Chemicals Industry Co., Ltd. and Honshu Chemical Industry Co., Ltd. Examples of the products include TMOM-BP (trade name) manufactured by Asahi Organic Chemicals Industry Co., Ltd.

Among the compounds, the glycoluril compound is preferred. Specifically, tetramethylol glycoluril, tetramethoxy glycoluril, tetramethoxymethyl glycoluril, a compound in which 1 to 4 methylol groups of tetramethylol glycoluril are methoxymethylated or a mixture thereof, and a compound in which 1 to 4 methylol groups of tetramethylol glycoluril are acyloxymethylated or a mixture thereof are preferred, and tetramethoxymethyl glycoluril is more preferred.

### <Acid catalyst>

Examples of the acid catalyst include inorganic acids such as hydrochloric acid, sulfuric acid, nitric acid, phosphoric acid, and phosphorous acid; organic acids such as formic acid, oxalic acid, acetic acid, diethyl sulfuric acid, and p-toluenesulfonic acid; and metal salts such as zinc acetate.

The content of the acid catalyst is, for example, preferably (0.01) to (10) parts by mass, more preferably (0.1) to (5) parts by mass, and still more preferably (0.5) to (3) parts by mass with respect to 100 parts by mass of the polymer.

In addition, a curing catalyst can be used as the acid catalyst.

### <Curing catalyst>

As the curing catalyst contained as an optional component in the resist underlayer film-forming composition, both a thermal acid generator and a photoacid generator can be used, and a thermal acid generator is preferably used.

Examples of the thermal acid generator include sulfonic acid compounds and carboxylic acid compounds such as p-toluenesulfonic acid, trifluoromethanesulfonic acid, pyridinium-p-toluenesulfonate (pyridinium-p-toluenesulfonic acid), pyridinium phenol sulfonic acid, pyridinium-p-hydroxybenzenesulfonic acid (pyridinium p-phenolsulfonic acid salt), pyridinium-trifluoromethanesulfonic acid, salicylic acid, camphorsulfonic acid, 5-sulfosalicylic acid, 4-chlorobenzenesulfonic acid, 4-hydroxybenzenesulfonic acid, benzenedisulfonic acid, 1-naphthalenesulfonic acid, citric acid, benzoic acid, and hydroxybenzoic acid.

Examples of the photoacid generator include onium salt compounds, sulfonimide compounds, and disulfonyldiazomethane compounds.

Examples of the onium salt compounds include iodonium salt compounds such as diphenyliodonium hexafluorophosphate, diphenyliodonium trifluoromethanesulfonate, diphenyliodonium nonafluoronormalbutanesulfonate, diphenyliodonium perfluoronormaloctanesulfonate, diphenyliodonium camphorsulfonate, bis(4-tert-butylphenyl)iodonium camphorsulfonate, and bis(4-tert-butylphenyl)iodonium trifluoromethanesulfonate, and sulfonium salt compounds such as triphenylsulfonium hexafluoroantimonate, triphenylsulfonium nonafluoronormalbutanesulfonate, triphenylsulfonium camphorsulfonate, and triphenylsulfonium trifluoromethanesulfonate.

Examples of the sulfonimide compounds include N-(trifluoromethanesulfonyloxy) succinimide, N-(nonafluoronormalbutanesulfonyloxy) succinimide, N-(camphorsulfonyloxy) succinimide, and N-(trifluoromethanesulfonyloxy) naphthalimide.

Examples of the disulfonyldiazomethane compounds include bis(trifluoromethylsulfonyl)diazomethane, bis(cyclohexylsulfonyl)diazomethane, bis(phenylsulfonyl)diazomethane, bis(p-toluenesulfonyl)diazomethane, bis(2,4-dimethylbenzenesulfonyl)diazomethane, and methylsulfonyl-p-toluenesulfonyl diazomethane.

Only one type of curing catalyst can be used, or two or more types thereof can be used in combination.

When a curing catalyst is used, the content ratio of the curing catalyst is, for example, 0.1 mass% to 50 mass%, preferably 1 mass% to 30 mass% with respect to the crosslinking agent.

### <Additive>

The semiconductor chip-manufacturing protective film-forming composition of the present invention may contain, as an additive, a light-absorbing compound, a surfactant, an adhesion aid, or a rheology controlling agent.

### <<Light-absorbing compound>>

The light-absorbing compound is not particularly limited as long as it is a compound having absorption at a wavelength of light used in exposure. A compound having an aromatic ring structure, such as an anthracene ring, a naphthalene ring, a benzene ring, a quinoline ring, and a triazine ring, is preferably used. From the viewpoint of not inhibiting the solubility of the semiconductor chip-manufacturing protective film in a removing liquid such as an alkaline removing liquid, a compound having a phenolic hydroxy group, a carboxy group, or a sulfonic acid group is preferably used.

Examples of the light-absorbing compound exhibiting large absorption for light having a wavelength of 248 nm include 1-naphthalenecarboxylic acid, 2-naphthalenecarboxylic acid, 1-naphthol, 2-naphthol, 1-aminonaphthalene, 1-hydroxy-2-naphthalenecarboxylic acid, 3-hydroxy-2-naphthalenecarboxylic acid, 3,7-dihydroxy-2-naphthalenecarboxylic acid, 6-bromo-2-hydroxynaphthalene, 1,2-naphthalenedicarboxylic acid, 1,3-naphthalenedicarboxylic acid, 1,4-naphthalenedicarboxylic acid, 1,5-naphthalenedicarboxylic acid, 1,6-naphthalenedicarboxylic acid, 1,7-naphthalenedicarboxylic acid, 1,8-naphthalenedicarboxylic acid, 2,3-naphthalenedicarboxylic acid, 2,6-naphthalenedicarboxylic acid, 1,2-dihydroxynaphthalene, 1,3-dihydroxynaphthalene, 1,4-dihydroxynaphthalene, 1,5-dihydroxynaphthalene, 1,6-dihydroxynaphthalene, 1,7-dihydroxynaphthalene, 1,8-dihydroxynaphthalene, 2,3-dihydroxynaphthalene, 2,6-dihydroxynaphthalene, 2,7-dihydroxynaphthalene, 6-hydroxy-1-naphthalenecarboxylic acid, 1-hydroxy-2-naphthalenecarboxylic acid, 3-hydroxy-2-naphthalenecarboxylic acid, 6-hydroxy-2-naphthalenecarboxylic acid, 1-bromo-2-hydroxy-3-naphthalenecarboxylic acid, 1-bromo-4-hydroxy-3-naphthalenecarboxylic acid, 1,6-dibromo-2-hydroxy-3-naphthalenecarboxylic acid, 3-hydroxy-7-methoxy-2-naphthalenecarboxylic acid, 1-amino-2-naphthol, 1,5-dimercaptonaphthalene, 1,4,5,8-naphthalenetetracarboxylic acid, 3,5-dihydroxy-2-naphthalenecarboxylic acid, 1,4-dihydroxy-2-naphthalenecarboxylic acid, 2-ethoxy-1-naphthalenecarboxylic acid, 2,6-dichloro-1-naphthol, methyl 2-hydroxy-3-naphthalenecarboxylate, methyl 6-hydroxy-2-naphthalenecarboxylate, methyl 3-hydroxy-7-methoxy-2-naphthalenecarboxylate, methyl 3,7-dihydroxy-2-naphthalenecarboxylate, 2,4-dibromo-1-naphthol, 1-bromo-2-naphthol, 2-naphthalenethiol, 4-methoxy-1-naphthol, 6-acetoxy-2-naphthalenecarboxylic acid, 1,6-dibromo-1-naphthol, 2,6-dibromo-1,5-dihydroxynaphthalene, 1-acetyl-2-naphthol, 9-anthracenecarboxylic acid, 1,4,9,10-tetrahydroxyanthracene, and 1,8,9-trihydroxyanthracene.

Examples of the light-absorbing compound exhibiting large absorption for light having a wavelength of 193 nm include benzoic acid, 4-methylbenzoic acid, o-phthalic acid, m-phthalic acid, p-phthalic acid, 2-methoxybenzoic acid, isophthalic acid, terephthalic acid, 2-hydroxybenzoic acid, 3-hydroxybenzoic acid, 4-hydroxybenzoic acid, 2-acetoxybenzoic acid, 2-aminobenzoic acid, 3-aminobenzoic acid, 4-aminobenzoic acid, trimesic acid, 1,4-benzenedicarboxylic acid, 2,3-dimethoxybenzoic acid, 2,4-dimethoxybenzoic acid, 2,5-dimethoxybenzoic acid, 2,4-dihydroxybenzoic acid, 2,6-dihydroxybenzoic acid, 3,4-dihydroxybenzoic acid, 3,5-dihydroxybenzoic acid, 4-acetyl benzoic acid, pyromellitic acid, trimesic anhydride, 2-[bis-(4-hydroxyphenyl)-methyl]benzoic acid, 3,4,5-trihydroxybenzoic acid, 2-benzophenone carboxylic acid, m-phenylbenzoic acid, 3-(4'-hydroxyphenoxy)benzoic acid, 3-phenoxybenzoic acid, phenol, 1,4-dihydroxybenzene, 1,3-dihydroxybenzene, 1,2-dihydroxybenzene, 2-methylphenol, 3-methylphenol, 4-methyphenol, 1,3,5-trihydroxybenzene, 2,2-bis-4-hydroxyphenylpropane, 2-hydroxybiphenyl, 2-aminophenol, 3-aminophenol, 4-aminophenol, and 4-benzyloxyphenol.

To prevent the sublimation during baking for forming the semiconductor chip-manufacturing protective film, the absorbent compound may be allowed to react with a polymer or a compound having one or more reactive groups before use.

For example, in the case of a light-absorbing compound having a carboxy group or a phenolic hydroxy group, there may be used a compound prepared by allowing the light-absorbing compound to react with a multifunctional epoxy compound such as tris(2,3-epoxypropyl) isocyanurate, 1,4-butanediol diglycidyl ether, 1,2-epoxy-4-(epoxyethyl)cyclohexane, glycerol triglycidyl ether, diethylene glycol diglycidyl ether, 2,6-diglycidyl phenyl glycidyl ether, 1,1,3-tris[p-(2,3-epoxypropoxy)phenyl]propane, 1,2-cyclohexanedicarboxylic acid diglycidyl ester, 4,4'-methylenebis(N,N-diglycidyl aniline), 3,4-epoxycyclohexylmethyl-3,4-epoxycyclohexanecarboxylate, trimethylolethane triglycidyl ether, bisphenol-A-diglycidyl ether, and pentaerythritol polyglycidyl ether, or with a polymer containing a structure having epoxy groups such as glycidyl methacrylate. Examples thereof include a polymer having a unit structure represented by the following (42), (43),or (44) and a compound represented by (45). In formula (45), Ar represents a benzene ring, a naphthalene ring, or an anthracene ring which may be substituted with an alkyl group having 1 to 5 carbon atoms, an alkoxy group having 1 to 5 carbon atoms, a fluorine atom, a chlorine atom, a bromine atom, an iodine atom, a nitro group, a cyano group, a hydroxy group, a thiol group, a thioalkyl group having 1 to 5 carbon atoms, a carboxy group, a phenoxy group, an acetyl group, an alkoxycarbonyl group having 1 to 5 carbon atoms, or a vinyl group.

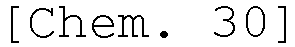

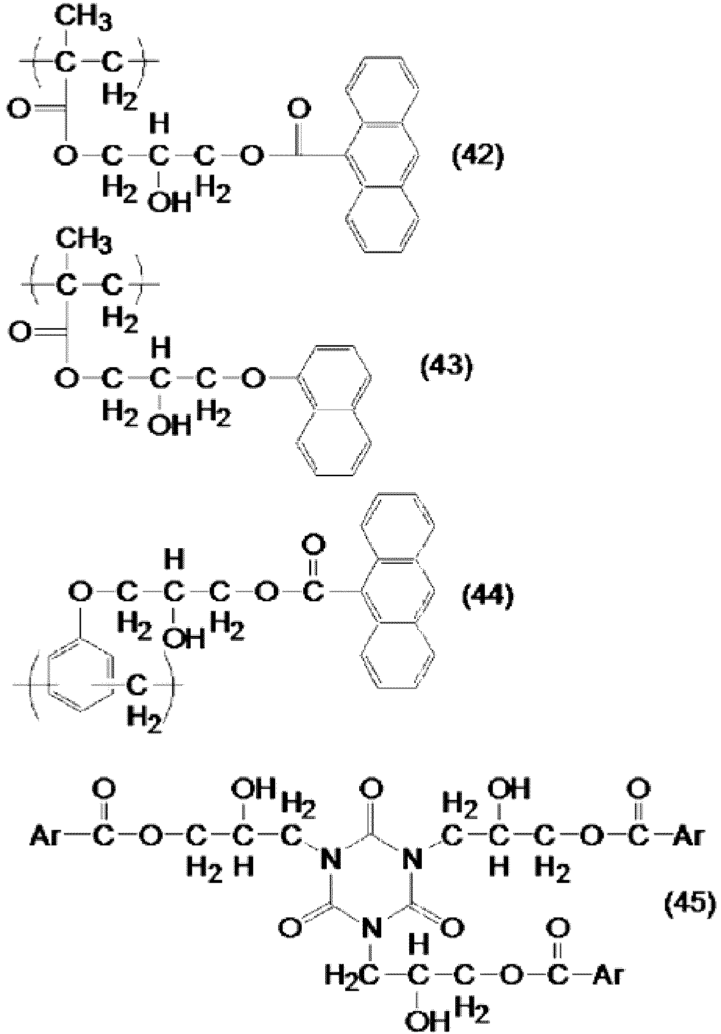

The above absorbent compounds can be used alone or two or more types thereof may be used in combination. When a light-absorbing compound is used, the content of the light-absorbing compound is, for example, 1 to 300 parts by mass or 1 to 200 parts by mass, and is, for example, 1 to 100 parts by mass or 5 to 100 parts by mass with respect to 100 parts by mass of the polymer. When the content of the absorbent compound exceeds 300 parts by mass, the solubility of the semiconductor chip-manufacturing protective film in a removing liquid such as an alkaline removing liquid may decrease.

The semiconductor chip-manufacturing protective film-forming composition of the present invention can contain an acid generator. Examples of the acid generator include thermal acid generators such as 2,4,4,6-tetrabromocyclohexadienone, benzoin tosylate, 2-nitrobenzyl tosylate, and other organic sulfonic acid alkyl esters, and photoacid generators, such as bis(4-tert-butylphenyl)iodonium trifluoromethanesulfonate, triphenylsulfonium trifluoromethanesulfonate, phenyl-bis(trichloromethyl)-s-triazine, benzoin tosylate, and N-hydroxysuccinimide trifluoromethanesulfonate. The amount of the acid generator added is 10 mass% or less, preferably 3 mass% or less in the solid content of the semiconductor chip-manufacturing protective film-forming composition, and the acid generator is used as necessary.

A polyhydric phenol compound or a carboxy group-containing compound can be added to the semiconductor chip-manufacturing protective film-forming composition of the present invention for the purpose of accelerating the dissolution rate in a removing liquid such as an alkaline removing liquid. Such a compound is not particularly limited, and examples thereof include polyhydric phenols, such as tris-hydroxyphenylethane, bisphenol-A, bisphenol-S, 4,4'-isopropylidene-di-o-cresol, 5-tert-butylpyrogallol, hexafluorobisphenol-A, 3,3,3',3'-tetramethyl-1,1'-spirobisindan-5,5',6,6'-tetrol, 4,4'-(9-fluorenylidene)diphenol, bisphenol-AP, bisphenol-P, 5-α,α-dimethyl-4-hydroxybenzylsalicylic acid, α,α,α'-tris(4-hydroxyphenyl)-1-ethyl-4-isopropylbenzene, 5,5'-di-tert-butyl-2,2',4,4'-tetrahydroxybenzophenone, polycarboxylic acids, such as pyromellitic acid, phthalic acid, trimellitic acid, 4-sulfophthalic acid, benzenehexacarboxylic acid, 2,3-naphthalenedicarboxylic acid, 4-hydroxyphthalic acid, 3,4-dihydroxyphthalic acid, 4,5-dihydroxyphthalic acid, 3,3'-,4,4'-biphenyltetracarboxylic acid, 3,3'-,4,4'-benzophenonetetracarboxylic acid, 3,3'-,4,4'-diphenyl ether tetracarboxylic acid, 3,3'-,4,4'-diphenyl sulfone tetracarboxylic acid, 1,2,3,4-cyclobutanetetracarboxylic acid, 1,2-dimethyl-1,2,3,4-cyclobutanetetracarboxylic acid, 1,2,3,4-tetramethyl-1,2,3,4-cyclobutanetetracarboxylic acid, 1,2,3,4-cyclopentanetetracarboxylic acid, 1,2,3,4-cyclohexanetetracarboxylic acid, and 3,4-dicarboxy-1,2,3,4-tetrahydro-1-naphthalenesuccinic acid, and carboxylic acid- or carboxylic anhydride-containing polymers, such as polyacrylic acid, polymethacrylic acid, polyamic acid, and polymaleic anhydride. The amount of the compound added is 20 mass% or less, preferably 10 mass% or less in the solid content of the semiconductor chip-manufacturing protective film-forming composition, and the compound is used as necessary.

For the purpose of controlling the dissolution rate in a removing liquid such as an alkaline removing liquid, a compound having a carboxy group or a phenolic hydroxy group protected by a group that is easily decomposed in the presence of an acid, such as a tert-butyl group, a tetrahydropyranyl group, a 1-ethoxyethyl group, or a trimethylsilyl group, may also be added to the semiconductor chip-manufacturing protective film-forming composition of the present invention.

Examples of such a compound include compounds such as di-tert-butyl malonate, tert-butyl acetate, tert-butyl propionate, tert-butyl acetoacetate, tert-amyl acetate, benzoic acid-tert-butyl ester, and tert-butyl pivalate. Additional examples of the compound include compounds of formulae (46) to (54).

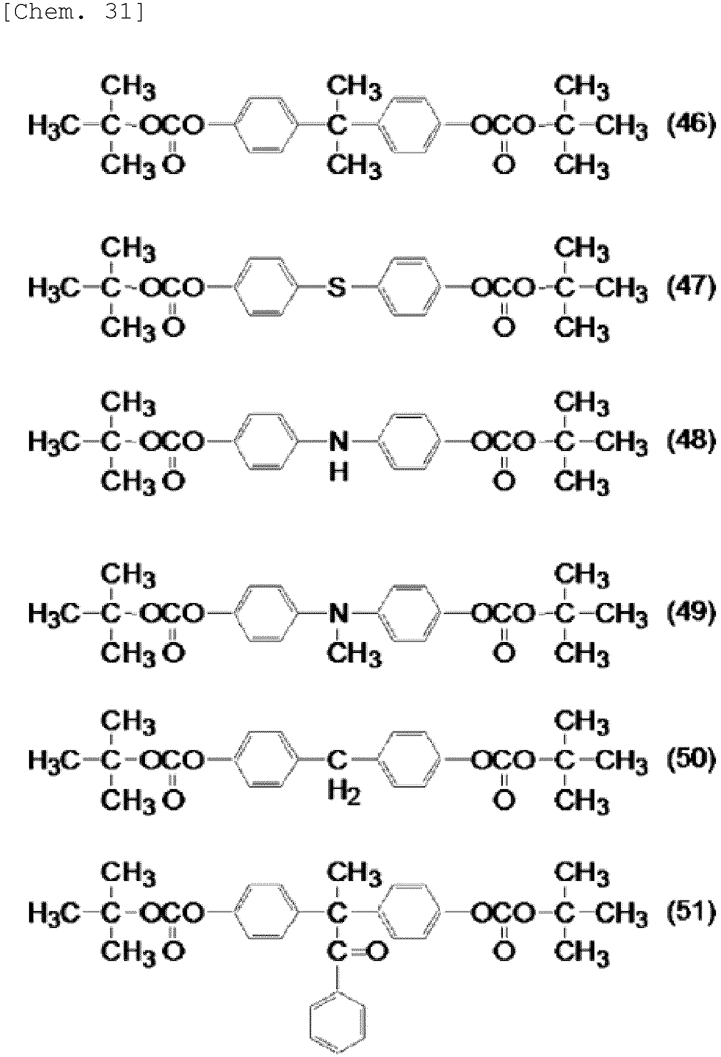

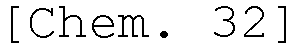

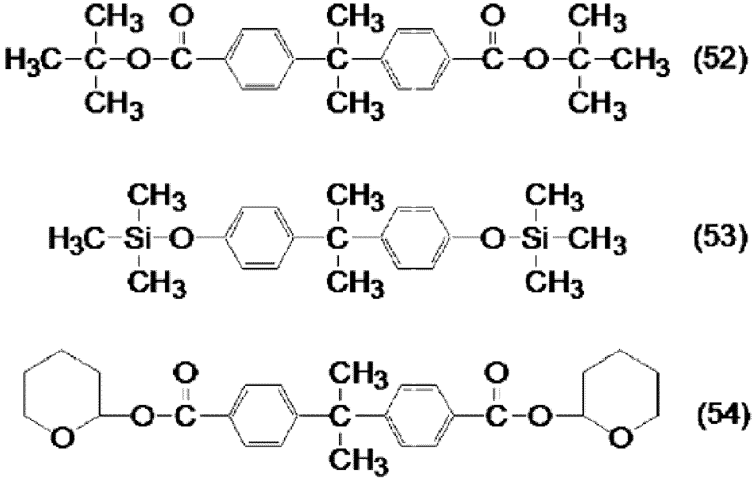

These compounds easily form a carboxy group or a phenolic hydroxy group in the presence of an acid, thereby providing a compound having an increased solubility in a removing liquid such as an alkaline removing liquid.

Accordingly, each of these compounds is preferably added to the semiconductor chip-manufacturing protective film-forming composition together with a photoacid generator. That is, with regard to the semiconductor chip-manufacturing protective film formed from the semiconductor chip-manufacturing protective film-forming composition containing the above-described compound having a carboxy group or a phenolic hydroxy group protected by a group that is easily decomposed in the presence of an acid and a photoacid generator, the acid generated from the photoacid generator due to the exposure in the exposed portion thereof regenerates the carboxy group or the phenolic hydroxy group of the compound having a carboxy group or a phenolic hydroxy group protected by a group that is easily decomposed in the presence of an acid, and as the result, the solubility of the exposed portion of the semiconductor chip-manufacturing protective film in a removing liquid is increased. In contrast, in the unexposed portion, there is no change in the compound having a carboxy group or a phenolic hydroxy group protected by a group that is easily decomposed in the presence of an acid. Hence, the solubility of the unexposed portion of the semiconductor chip-manufacturing protective film in a removing liquid is not increased. Accordingly, it becomes possible to cause a difference in the solubility in a removing liquid between the exposed portion and the unexposed portion of the semiconductor chip-manufacturing protective film after the exposure by the use of the compound having a carboxy group or a phenolic hydroxy group protected by a group that is easily decomposed in the presence of an acid and the photoacid generator, which facilitates the pattern formation by development.

When the above-described compound having a carboxy group or a phenolic hydroxy group protected by a group that is easily decomposed in the presence of an acid is used, the content of the compound is, for example, 50 to 1 part by mass, or 30 to 5 parts by mass, or, for example, 20 to 10 parts by mass with respect to 100 parts by mass of the polymer. When a photoacid generator is used together with the compound having a carboxy group or a phenolic hydroxy group protected by a group that is easily decomposed in the presence of an acid, the content of the photoacid generator is, for example, 0.1 to 30 parts by mass, or 0.5 to 20 parts by mass, or, for example, 1 to 10 parts by mass with respect to 100 parts by mass of the compound having a carboxy group or a phenolic hydroxy group protected by a group that is easily decomposed in the presence of an acid.

### <<Surfactant>>

The semiconductor chip-manufacturing protective film-forming composition of the present invention can contain a surfactant. Examples of the surfactant include nonionic surfactants, such as polyoxyethylene alkyl ethers, such as polyoxyethylene lauryl ether, polyoxyethylene stearyl ether, polyoxyethylene cetyl ether, and polyoxyethylene oleyl ether, polyoxyethylene alkyl allyl ethers, such as polyoxyethylene octyl phenol ether and polyoxyethylene nonyl phenol ether, polyoxyethylene/polyoxypropylene block copolymers, sorbitan fatty acid esters, such as sorbitan monolaurate, sorbitan monopalmitate, sorbitan monostearate, sorbitan monooleate, sorbitan trioleate, and sorbitan tristearate, and polyoxyethylene sorbitan fatty acid esters, such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate, fluorine-based surfactants, such as EFUTOP EF301, EF303, and EF352 (trade names, manufactured by TOKEM PRODUCTS), MEGAFACE F171 and F173 (trade names, manufactured by Dainippon Ink and Chemicals, Inc.), Fluorad FC430 and FC431 (trade names, manufactured by Sumitomo 3M Limited), AsahiGuard AG710, Surflon S-382, SC101, SC102, SC103, SC104, SC105, and SC106 (trade names, manufactured by Asahi Glass Co., Ltd.), and an organosiloxane polymer KP341 (trade name, manufactured by Shin-Etsu Chemical Co., Ltd.). The blending amount of these surfactants is usually 0.2 mass% or less, preferably 0.1 mass% or less with respect to all components of the semiconductor chip-manufacturing protective film-forming composition of the present invention. These surfactants may be added alone, or two or more types thereof can also be added in combination.

### (Semiconductor chip-manufacturing protective film)

The semiconductor chip-manufacturing protective film of the present invention is formed using the semiconductor chip-manufacturing protective film-forming composition of the present invention described above, and is a baked product of a coating film formed of the semiconductor chip-manufacturing protective film-forming composition.

The semiconductor chip-manufacturing protective film-forming composition of the present invention is applied onto a semiconductor substrate (for example, a silicon/silicon dioxide-coated substrate, a silicon nitride substrate, a glass substrate, an ITO substrate, or the like) by an appropriate coating method such as rotational coating (spin coating), cast coating, or roll coating, and then baked to form a semiconductor chip-manufacturing protective film. The baking conditions are appropriately selected from a baking temperature of 80°C to 300°C, and a baking time of 0.3 to 60 minutes.

The coating film is then heated (baked) or heated under reduced pressure to efficiently remove some or all of the solvent contained in the coating film, thereby accelerating solidification and/or curing of the solid content contained in the coating film. The term "solidification" as used herein means becoming solid, and the term "curing" means an increase in molecular weight (for example, crosslinking or polymerization) due to the linkage of molecules. In this way, the semiconductor chip-manufacturing protective film is formed.

When the semiconductor chip-manufacturing protective film-forming composition of the present invention is used, a coating film can be formed using, for example, a coating method such as rotational coating (spin coating), cast coating, or roll coating as described above. That is, when the semiconductor chip-manufacturing protective film-forming composition of the present invention is used, a coating film can be quickly and uniformly formed on a semiconductor substrate by a simple method.

As described above, when the semiconductor chip-manufacturing protective film-forming composition of the present invention is used, a semiconductor chip-manufacturing protective film can be formed on a semiconductor substrate by a simple method, and a semiconductor substrate with a semiconductor chip-manufacturing protective film can be easily manufactured.

The thickness of the semiconductor chip-manufacturing protective film of the present invention is usually 1 to 10 µm, and preferably 1 to 3 µm.

The dissolution rate of the semiconductor chip-manufacturing protective film to be formed in the developer for a photoresist is 0.1 nm to 50 nm per second, preferably 0.2 nm to 40 nm per second, and more preferably 0.3 to 20 nm. When the dissolution rate is smaller than this range, the time required to remove the semiconductor chip-manufacturing protective film becomes long, leading to deterioration of productivity.

The semiconductor chip-manufacturing protective film formed from the semiconductor chip-manufacturing protective film-forming composition of the present invention enables control of the dissolution rate of the semiconductor chip-manufacturing protective film in a removing liquid by changing the baking conditions in the formation. In the case of a constant baking time, as the baking temperature is increased, a semiconductor chip-manufacturing protective film having a smaller dissolution rate in a removing liquid can be formed.

The semiconductor chip-manufacturing protective film of the present invention may be exposed after formation of the film. The surface of a wafer may be fully exposed to light, or may be exposed through a mask having a predetermined pattern. The light exposure may be performed using a KrF excimer laser (wavelength: 248 nm), an ArF excimer laser (wavelength: 193 nm), an F2 excimer laser (wavelength: 157 nm), or the like. After the light exposure, post exposure bake (PEB) may be performed as necessary.

Subsequently, the semiconductor chip-manufacturing protective film is removed with a removing liquid.

The semiconductor chip-manufacturing protective film is formed on, for example, a semiconductor substrate or a semiconductor chip as described later. In this case, the removal refers to removal from the semiconductor substrate or the semiconductor chip.

### <Removing liquid>

The removing liquid may be any liquid as long as the semiconductor chip-manufacturing protective film can be removed from the semiconductor substrate or the semiconductor chip, and examples thereof include an alkaline removing liquid, an acidic removing liquid, a neutral removing liquid, and an organic solvent.

The removing liquid may contain water or an organic solvent.

The removing liquid may be a removing liquid that contains an organic solvent in an amount of 50 mass% or more.

Examples of the organic solvent include ethylene glycol monomethyl ether, ethylene glycol monoethyl ether, methyl cellosolve acetate, ethyl cellosolve acetate, diethylene glycol monomethyl ether, diethylene glycol monoethyl ether, propylene glycol, propylene glycol monomethyl ether, propylene glycol monomethyl ether acetate, propylene glycol propyl ether acetate, toluene, xylene, methyl ethyl ketone, cyclopentanone, cyclohexanone, ethyl 2-hydroxypropionate, ethyl 2-hydroxy-2-methylpropionate, ethyl ethoxyacetate, ethyl hydroxyacetate, methyl 2-hydroxy-3-methylbutanoate, methyl 3-methoxypropionate, ethyl 3-methoxypropionate, ethyl 3-ethoxypropionate, methyl 3-ethoxypropionate, methyl pyruvate, ethyl pyruvate, ethyl acetate, butyl acetate, ethyl lactate, butyl lactate, N,N-dimethylformamide, N,N-dimethylacetamide, and N-methylpyrrolidone.

Examples of the removing liquid include an alkaline removing liquid, an acidic removing liquid, and a neutral removing liquid.

Among them, an alkaline removing liquid or an acidic removing liquid is preferred, and an alkaline removing liquid is more preferred from the viewpoint that the semiconductor chip-manufacturing protective film can be effectively dissolved and removed.

The alkaline removing liquid contains an alkali. Examples of the alkali include ammonia, an inorganic alkaline compound, quaternary ammonium hydroxide, an amine, and hydrazine.

The alkaline removing liquid is a developer or a cleaning liquid used in a semiconductor manufacturing process, and may exhibit alkalinity. Examples of the developer include NMD-3 (2.38% tetramethylammonium hydroxide aqueous solution, manufactured by TOKYO OHKA

### KOGYO CO., LTD.).

Examples of the inorganic alkaline compound include potassium hydroxide, sodium hydroxide, lithium hydroxide, diammonium hydrogen phosphate, dipotassium hydrogen phosphate, disodium hydrogen phosphate, lithium silicate, sodium silicate, potassium silicate, lithium carbonate, sodium carbonate, potassium carbonate, lithium borate, sodium borate, and potassium borate.

Examples of the quaternary ammonium hydroxide include tetramethylammonium hydroxide, tetraethylammonium hydroxide, trimethylhydroxyethylammonium hydroxide, and choline.

Examples of the amine include ethanolamine, methylamine, dimethylamine, trimethylamine, monoethylamine, diethylamine, triethylamine, n-propylamine, di-n-propylamine, isopropylamine, diisopropylamine, methyldiethylamine, dimethylethanolamine, triethanolamine, and ethylenediamine.

Examples of the hydrazine include hydrazine monohydrate.

The alkaline removing liquid may be SC-1 (ammonia-hydrogen peroxide solution).

The acidic removing liquid contains an acid. Examples of the acid include an inorganic acid and an organic acid. Examples of the inorganic acid include sulfuric acid, nitric acid, hydrochloric acid, phosphoric acid, and hydrofluoric acid.

The acidic removing liquid is, for example, an aqueous solution containing dilute hydrofluoric acid.

The acidic removing liquid may be, for example, an aqueous solution containing sulfuric acid and hydrogen peroxide, or an aqueous solution containing acetic acid or a chelating agent. Examples of the chelating agent include an organic acid, a salt of an organic acid, an amino acid, and a derivative of an amino acid.

The expression that the semiconductor chip-manufacturing protective film of the present invention is dissolved in a removing liquid means that when the protective film is immersed, cleaned, or the like with the removing liquid, the protective film is dissolved in the removing liquid, and no longer exists on the semiconductor substrate or the semiconductor chip. The term "dissolved (or dissolution)" in the present invention means, for example, that at least 90% or more of the thickness of the film originally formed is removed (that is, the thickness of the residual film is 10% or less that of the original film), or at least 95% or more of the thickness of the original film is removed (that is, the thickness of the residual film is 5% or less that of the original film), or at least 99% or more of the thickness of the original film is removed (that is, the thickness of the residual film is 1% or less that of the original film), and most preferably 100% of the thickness of the original film is removed (that is, the thickness of the residual film is 0% of the thickness of the original film (no residual film remains)), from the protective film formed on the semiconductor substrate.

### (Semiconductor substrate)

The semiconductor substrate of the present invention has a semiconductor chip-manufacturing protective film obtained using the semiconductor chip-manufacturing protective film-forming composition of the present invention thereon.

The main material constituting the entire semiconductor substrate is not particularly limited as long as the material is used for this type of application, and examples thereof include silicon, silicon carbide, and a compound semiconductor.

The shape of the semiconductor substrate is not particularly limited, and is, for example, a disk shape. Note that the disk-shaped semiconductor substrate does not need to have a completely circular surface, and for example, the outer periphery of the semiconductor substrate may have a linear portion called an orientation flat or may have a cut called a notch.

The thickness of the disk-shaped semiconductor substrate may be appropriately determined depending on the purpose of use of the semiconductor substrate and the like, and is not particularly limited, but is, for example, 500 to 1,000 µm.

The diameter of the disk-shaped semiconductor substrate may be appropriately determined depending on the purpose of use of the semiconductor substrate and the like, and is not particularly limited, but is, for example, 100 to 1,000 mm.

The semiconductor substrate may have a bump. The bump is a protruding terminal.

In the semiconductor substrate, the bump is usually formed on a surface on which a circuit is formed. The circuit may be a single layer or a multilayer. The shape of the circuit is not particularly limited.

In the semiconductor substrate, a surface (back surface) opposite to the surface (front surface) having the bump is a surface to be processed.

The material, size, shape, structure, and density of the bump of the semiconductor substrate are not particularly limited.

Examples of the bump include a ball bump, a print bump, a stud bump, and a plating bump.

Usually, the height, radius, and pitch of the bump are appropriately determined from the conditions of a bump height of approximately 1 to 200 µm, a bump radius of 1 to 200 µm, and a bump pitch of 1 to 500 µm.

Examples of the material of the bump include low melting point solder, high melting point solder, tin, indium, gold, silver, and copper. The bump may be formed of only a single component or may be formed of a plurality of components. More specific examples thereof include alloy plate mainly containing Sn, such as SnAg bumps, SnBi bumps, Sn bumps, and AuSn bumps.

In addition, the bump may have a laminated structure including a metal layer made of at least one of these components.

An example of the semiconductor substrate is a silicon wafer having a diameter of about 300 mm and a thickness of about 770 µm.

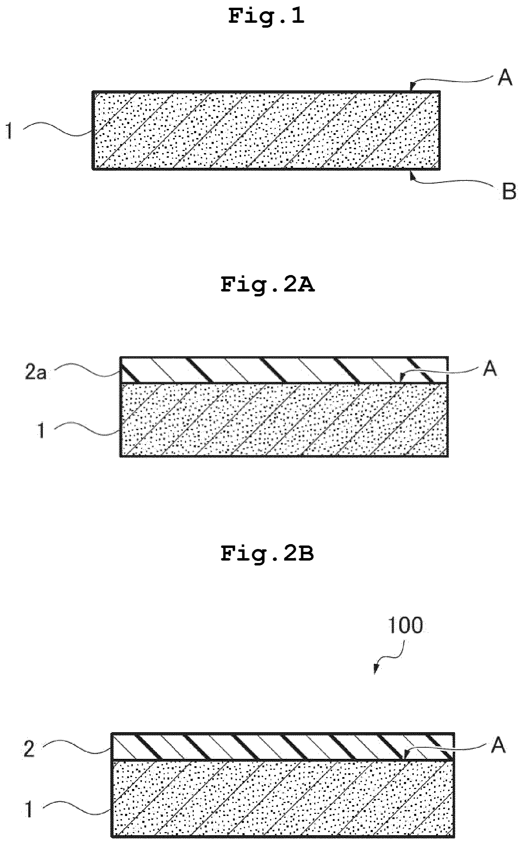

A schematic cross-sectional view illustrating an example of the semiconductor substrate having the semiconductor chip-manufacturing protective film of the present invention is shown in Fig. 2B. Fig. 2B illustrates a protective film-attached semiconductor substrate 100 in which a semiconductor chip-manufacturing protective film 2 is formed on a side of a front surface A, on which a circuit surface is formed, of a semiconductor substrate 1.

The protective film-attached semiconductor substrate 100 illustrated in Fig. 2B can be obtained as follows.

As illustrated in Fig. 1, it is assumed that there is a semiconductor substrate 1 and a circuit is formed on the semiconductor substrate. For example, a surface on a side on which a circuit is formed is referred to as a front surface A, and a surface on a side opposite to the side on which the circuit is formed is referred to as a back surface B.

A coating film 2a of a semiconductor chip-manufacturing protective film-forming composition is formed on the front surface A side of the semiconductor substrate 1 (Fig. 2A). By baking the coating film 2a, the semiconductor chip-manufacturing protective film 2 can be formed on the semiconductor substrate 1. Thus, the protective film-attached semiconductor substrate 100 can be obtained (Fig. 2B).

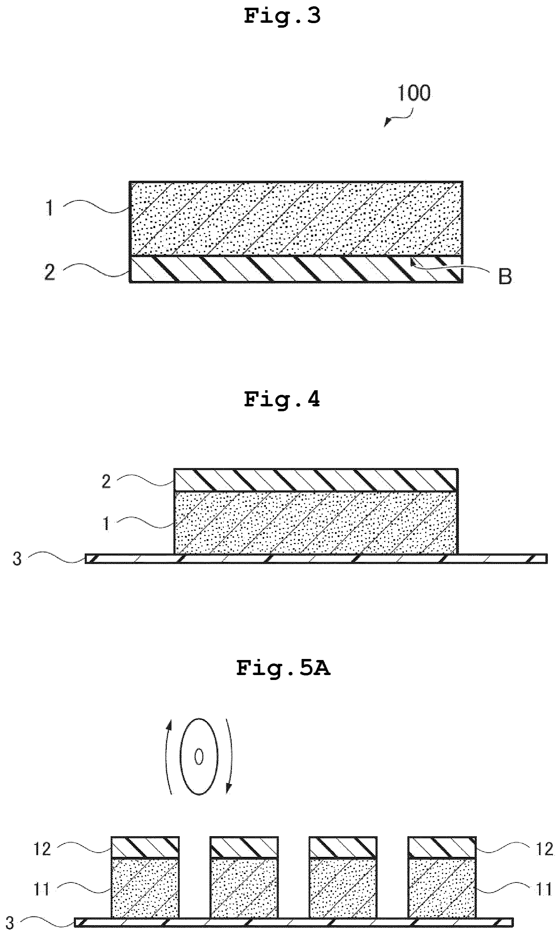

An object of the present invention is to protect a semiconductor chip from damage accompanying transportation when the semiconductor chip is transported, and it is sufficient that a semiconductor chip-manufacturing protective film is disposed on the semiconductor chip, and therefore, the semiconductor chip-manufacturing protective film can be disposed on either of the front surface and the back surface of the semiconductor chip. That is, the semiconductor chip-manufacturing protective film may be disposed on either the front surface A side or the back surface B side of the semiconductor substrate. Therefore, the semiconductor chip-manufacturing protective film 2 may be disposed not only on the front surface A side of the semiconductor substrate 1 (see Fig. 2B) but also on the back surface B side of the semiconductor substrate 1 as illustrated in Fig. 3.

### (Semiconductor chip)

The semiconductor chip of the present invention has a semiconductor chip-manufacturing protective film obtained using the semiconductor chip-manufacturing protective film-forming composition of the present invention thereon.

The semiconductor chip with the semiconductor chip-manufacturing protective film of the present invention can be obtained by dicing a semiconductor chip-manufacturing protective film-attached semiconductor substrate having a semiconductor chip-manufacturing protective film formed on a semiconductor substrate.

The semiconductor chip of the present invention may be placed on an electronic component and used as a part of the electronic component.

Examples of the electronic component include an integrated circuit (IC) chip and a semiconductor element including an IC chip.

Examples of the semiconductor element including an IC chip include a ball grid array (BGA), a chip-scale package (CSP), a pin grid array (PGA), and a line grid array (LGA).

### (Method for manufacturing semiconductor chip)

The method for manufacturing a semiconductor chip of the present invention includes a first step, a second step, and a third step, and may further include a fourth step.

The first step is a step of applying the semiconductor chip-manufacturing protective film-forming composition of the present invention onto a semiconductor substrate, followed by baking to form a semiconductor chip-manufacturing protective film.

The second step is a step of dicing the semiconductor substrate with the semiconductor chip-manufacturing protective film disposed thereon to obtain a semiconductor chip with the semiconductor chip-manufacturing protective film.

The third step is a step of transporting the semiconductor chip.

The fourth step is a step of removing the semiconductor chip-manufacturing protective film from the semiconductor chip by cleaning with an alkaline removing liquid.

### <First step>

The first step is a step of applying the semiconductor chip-manufacturing protective film-forming composition of the present invention onto a semiconductor substrate, followed by baking to form a semiconductor chip-manufacturing protective film.

The first step is as described above with reference to Figs. 2A and 2B. By forming a coating film 2a of a semiconductor chip-manufacturing protective film-forming composition on a semiconductor substrate 1 (Fig. 2A) and baking the coating film 2a, a protective film-attached semiconductor substrate 100 in which a semiconductor chip-manufacturing protective film 2 is disposed on the semiconductor substrate 1 can be obtained (Fig. 2B).

### <Second step>

The second step is a step of dicing the semiconductor substrate with the semiconductor chip-manufacturing protective film disposed thereon to obtain a semiconductor chip with the semiconductor chip-manufacturing protective film.

When the protective film-attached semiconductor substrate 100 obtained in Fig. 2B is placed on, for example, a support sheet (dicing tape) 3 (see Fig. 4) and then subjected to a dicing step, a semiconductor chip with a semiconductor chip-manufacturing protective film can be obtained (see Fig. 5A).

### <Third step>

The third step is a step of transporting the semiconductor chip.

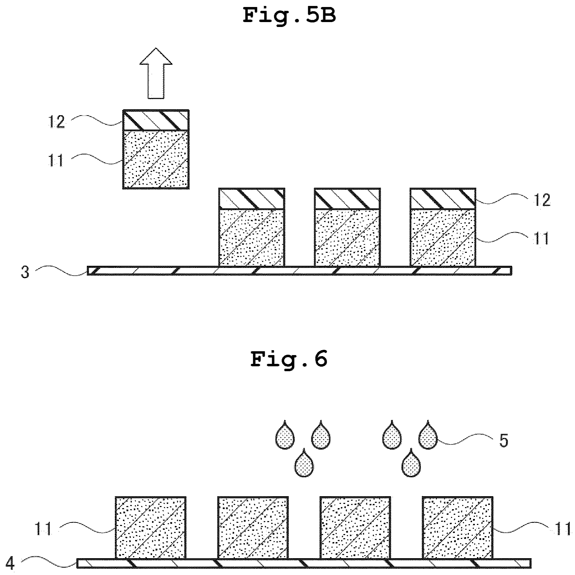

An individual semiconductor chip with a semiconductor chip-manufacturing protective film obtained in Fig. 5A is transported and placed on a support sheet or various electronic components such as a printed circuit board using a transporting unit such as a robot arm (see Fig. 5B).

Since the semiconductor chip-manufacturing protective film is disposed on the semiconductor chip, it is possible to effectively prevent the semiconductor chip from being damaged or ruptured due to physical contact, which may occur when the semiconductor chip is transported.

### <Fourth step>

The fourth step is a step of removing the semiconductor chip-manufacturing protective film from the semiconductor chip by cleaning with a removing liquid.

When a semiconductor chip 11 with a semiconductor chip-manufacturing protective film 12 in Fig. 5B is placed on a separate support sheet 4 and subjected to a cleaning step, the semiconductor chip-manufacturing protective film 12 is dissolved in a removing liquid 5 which is a cleaning liquid, and the semiconductor chip-manufacturing protective film 12 is removed from the semiconductor chip 11 (see Fig. 6).

Examples of the removing liquid used in the cleaning step include the removing liquids listed in the explanation section for the semiconductor chip-manufacturing protective film.

The cleaning method is not particularly limited, and examples thereof include a method of immersing the semiconductor substrate on which the semiconductor chip-manufacturing protective film remains in an alkaline removing liquid, and a method of spraying an alkaline removing liquid onto the semiconductor substrate on which the semiconductor chip-manufacturing protective film remains.

Conditions for cleaning are not particularly limited, and for example, the temperature of the cleaning liquid is 5°C to 50°C. The cleaning time is appropriately selected from 2 to 500 seconds or 3 to 400 seconds.

For example, it is preferred that the semiconductor chip-manufacturing protective film can be easily peeled off at room temperature (for example, 25°C) using a widely used 2.38 mass% tetramethylammonium hydroxide aqueous solution.

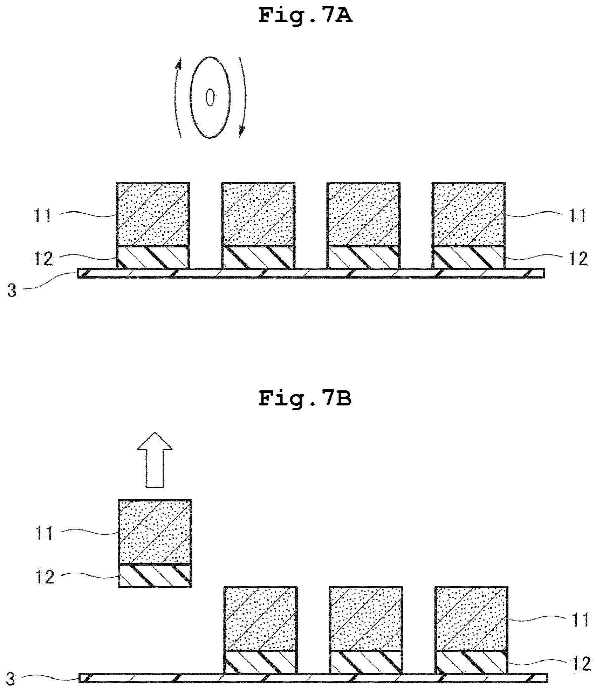

In the <first step>, a case where the coating film 2a of the semiconductor chip-manufacturing protective film-forming composition is formed on the front surface A side of the semiconductor substrate 1 has been described as an example, but in a case where the coating film 2a of the semiconductor chip-manufacturing protective film-forming composition is formed on the back surface B side of the semiconductor substrate 1, the <second step> and the <third step> are as shown in Figs. 7A and 7B.

When the protective film-attached semiconductor substrate 100 obtained in Fig. 3 is placed on, for example, a support sheet (dicing tape) and then subjected to the dicing step, a semiconductor chip with a semiconductor chip-manufacturing protective film can be obtained (see Fig. 7A).

An individual semiconductor chip with a semiconductor chip-manufacturing protective film obtained in Fig. 7A is transported and placed on a support sheet or various electronic components such as a printed circuit board using a transporting unit such as a robot arm (see Fig. 7B).

Since the semiconductor chip-manufacturing protective film is disposed on the semiconductor chip, it is possible to effectively prevent the semiconductor chip from being damaged or ruptured due to physical contact, which may occur when the semiconductor chip is transported.

The method for manufacturing a semiconductor chip of the present invention includes the first step to the third step (preferably includes the fourth step), but may include another step. For example, various processing treatment steps such as a polishing treatment and a through-electrode formation treatment for a semiconductor substrate performed at the time of a post-process treatment for a semiconductor substrate with a circuit formed thereon may be included.

For example, the semiconductor chip-manufacturing protective film-forming composition of the present invention is applied onto the surface of the semiconductor substrate with a circuit formed thereon, followed by baking to form a semiconductor chip-manufacturing protective film.

Subsequently, the semiconductor chip-manufacturing protective film-attached semiconductor substrate is disposed such that the semiconductor chip-manufacturing protective film is on a support tape 1 (background tape) side, and the semiconductor chip-manufacturing protective film-attached semiconductor substrate is temporarily adhered onto the support tape 1.

The back surface of the semiconductor substrate is subjected to a polishing treatment to thin the semiconductor substrate.

Thereafter, the semiconductor chip-manufacturing protective film and the support tape 1 are peeled off.

Subsequently, the semiconductor chip-manufacturing protective film-attached semiconductor substrate is disposed such that the back surface of the semiconductor substrate is on a support tape 2 (dicing tape) side, and the semiconductor chip-manufacturing protective film-attached semiconductor substrate is attached onto the support tape 2.

The semiconductor substrate with the semiconductor chip-manufacturing protective film disposed thereon is diced to obtain a semiconductor chip with a semiconductor chip-manufacturing protective film.

A semiconductor chip with a semiconductor chip-manufacturing protective film is transported and placed on another support sheet 3 or various electronic components such as a printed circuit board using a transporting unit.

### Examples

Hereinafter, the present invention will be described more specifically with reference to Examples, but the present invention is not limited thereto.

### (Example 1)

### (Preparation of semiconductor chip-manufacturing protective film-forming composition)

To 16.45 g of polyhydroxystyrene (product name: VP-8000, manufactured by Nippon Soda Co., Ltd.), 0.04 g of a surfactant (product name: MEGAFACE R-40, manufactured by DIC Corporation), 75.15 g of propylene glycol monomethyl ether, and 8.35 g of propylene glycol monomethyl ether acetate were added to prepare a solution. The solution was filtered using a polyethylene filter having a pore size of 0.03 µm to prepare a semiconductor chip-manufacturing protective film-forming composition.

### (Evaluation of semiconductor chip-manufacturing protective film-forming composition)

A solution of this semiconductor chip-manufacturing protective film-forming composition was applied (spin coated) onto a silicon wafer with a spin coater. The silicon wafer after application was heated on a hot plate at 200°C for 1 minute to form a coating film (semiconductor chip-manufacturing protective film) having a thickness of 1500 nm.

A semiconductor chip-manufacturing protective film-attached wafer was sucked and held for 1 minute under the condition of a load at the time of suction of 4 kg using a die bonder T-3000-PRO (manufactured by Dr. Tresky, collet diameter: 1 mm) having suction holes from the protective film surface side of the semiconductor chip-manufacturing protective film-attached wafer. Thereafter, the suction by the die bonder was stopped, and the obtained wafer was immersed in a 2.38% tetramethylammonium hydroxide aqueous solution (NMD-3, manufactured by TOKYO OHKA KOGYO CO., LTD.) for 2 minutes.

It was verified that a film obtained from the semiconductor chip-manufacturing protective film-forming composition prepared in Example 1 was completely dissolved in NMD-3.

The upper surface of the wafer after being treated with NMD-3 was observed with an optical microscope and evaluated according to the following criteria.
∘; No suction marks are visible at all.
×; Suction marks are visible.

The result of evaluation performed according to the above criteria for the semiconductor chip-manufacturing protective film-attached wafer obtained in Example 1 is shown in Table 1 below.

### (Comparative Example 1)

Meanwhile, in Comparative Example 1, a silicon wafer without forming a film of a semiconductor chip-manufacturing protective film-forming composition was used, and the silicon wafer was sucked and held for 1 minute under the condition of a load at the time of suction of 4 kg using a die bonder T-3000-PRO having suction holes as in Example 1, and then the upper surface of the wafer after being treated with NMD-3 was observed with an optical microscope.

The result of evaluation performed according to the above criteria for the silicon wafer obtained in Comparative Example 1 is shown in Table 1 below.

**[Table 1]**

| | Semiconductor chip-manufacturing protective film | Evaluation result |
|---|---|---|
| Example 1 | Protective film of Example 1 | ○ |
| Comparative Example 1 | None | × |

In Example 1 in which the semiconductor chip-manufacturing protective film of the present invention is included, no suction marks were observed. On the other hand, in Comparative Example 1 in which the semiconductor chip-manufacturing protective film of the present invention is not included, suction marks were observed.

### Reference Signs List

- 1: Semiconductor substrate
- A: Front surface
- B: Back surface
- 2a: Coating film
- 2: Semiconductor chip-manufacturing protective film
- 100: Semiconductor chip-manufacturing protective film- attached semiconductor substrate
- 3: Support sheet (dicing tape)
- 4: Another support sheet
- 5: Alkaline removing liquid
- 11: Semiconductor chip
- 12: Semiconductor chip-manufacturing protective film

## Claims

1. A semiconductor chip-manufacturing protective film-forming composition for preventing damage to a circuit surface or a back surface of a semiconductor substrate or a semiconductor chip,
the semiconductor chip-manufacturing protective film-forming composition comprising a polymer and a solvent, wherein
the polymer is selected from a phenolic hydroxy group-containing polymer, a carboxy group-containing polymer, and a blocked carboxy group-containing polymer.

2. The semiconductor chip-manufacturing protective film-forming composition according to claim 1, wherein the semiconductor chip-manufacturing protective film-forming composition forms a protective film that can be dissolved in an alkaline removing liquid, an acidic removing liquid, a neutral removing liquid, or an organic solvent.

3. The semiconductor chip-manufacturing protective film-forming composition according to claim 1, wherein the semiconductor chip-manufacturing protective film-forming composition contains the polymer in an amount of 50 mass% or more with respect to the entire solid content in the composition.

4. The semiconductor chip-manufacturing protective film-forming composition according to claim 1, wherein when an individual semiconductor chip obtained by dicing a semiconductor substrate is transported, the semiconductor chip-manufacturing protective film is disposed on the semiconductor substrate in order to protect the semiconductor chip from damage accompanying the transportation.

5. The semiconductor chip-manufacturing protective film-forming composition according to claim 1, wherein the phenolic hydroxy group-containing polymer is selected from any of phenol novolac, naphthol novolac, a polyhydroxystyrene, a polyhydroxyphenyl (meth)acrylate, and a poly(N-hydroxyphenyl (meth)acrylamide).

6. The semiconductor chip-manufacturing protective film-forming composition according to claim 1, wherein the carboxy group-containing polymer is selected from any of a (meth)acrylic resin, polyvinylbenzoic acid, carboxymethyl cellulose, and a polyamic acid.

7. The semiconductor chip-manufacturing protective film-forming composition according to claim 6, wherein the polyamic acid is a polyamic acid having a structural unit derived from a tetracarboxylic dianhydride compound (a) and a diamine compound having at least one carboxy group (b).

8. The semiconductor chip-manufacturing protective film-forming composition according to claim 1, wherein the semiconductor chip-manufacturing protective film-forming composition contains at least one of a crosslinking agent, an acid catalyst, and an additive.

9. The semiconductor chip-manufacturing protective film-forming composition according to claim 8, wherein the crosslinking agent is selected from any of an aminoplast crosslinking agent, a phenoplast crosslinking agent, and a crosslinking agent containing an epoxy group.

10. A semiconductor chip-manufacturing protective film, which is a baked product of a coating film formed of the semiconductor chip-manufacturing protective film-forming composition according to any one of claims 1 to 9.

11. The semiconductor chip-manufacturing protective film according to claim 10, wherein the semiconductor chip-manufacturing protective film has a thickness of 1 to 10 µm.

12. A semiconductor substrate comprising the semiconductor chip-manufacturing protective film according to claim 10.

13. A semiconductor chip comprising the semiconductor chip-manufacturing protective film according to claim 10.

14. A method for manufacturing a semiconductor chip, the method comprising a step of applying the semiconductor chip-manufacturing protective film-forming composition according to any one of claims 1 to 9 onto a semiconductor substrate, followed by baking to form a semiconductor chip-manufacturing protective film, a step of dicing the semiconductor substrate with the semiconductor chip-manufacturing protective film disposed thereon to obtain a semiconductor chip with the semiconductor chip-manufacturing protective film, and a step of transporting the semiconductor chip.

15. The method for manufacturing a semiconductor chip according to claim 14, further comprising a step of removing the semiconductor chip-manufacturing protective film from the semiconductor chip by cleaning with an alkaline removing liquid, an acidic removing liquid, a neutral removing liquid, or an organic solvent.
